(19) **Europäisches Patentamt European Patent Office Office européen des brevets**

(11) **EP 4 471 501 A1**

(12) **EUROPEAN PATENT APPLICATION**
published in accordance with Art. 153(4) EPC

(43) Date of publication:
04.12.2024 Bulletin 2024/49

(21) Application number: 22923857.1

(22) Date of filing: 28.01.2022

(51) International Patent Classification (IPC):
*G03F 7/20* (2006.01)

(52) Cooperative Patent Classification (CPC):
G03F 7/20

(86) International application number:
PCT/JP2022/003289

(87) International publication number:
WO 2023/144993 (03.08.2023 Gazette 2023/31)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: NIKON CORPORATION
Minato-ku
Tokyo 108-6290 (JP)

(72) Inventors:
• OCHINO Arata
Tokyo 108-6290 (JP)

• ASAI Kenta
Tokyo 108-6290 (JP)
• KIDA Yoshiki
Tokyo 108-6290 (JP)
• MORO Masatoshi
Tokyo 108-6290 (JP)
• TSUJI Hiroaki
Tokyo 108-6290 (JP)
• YOSHIDA Masahiro
Tokyo 108-6290 (JP)
• SUDA Takayuki
Tokyo 108-6290 (JP)

(74) Representative: Hoffmann Eitle
Patent- und Rechtsanwälte PartmbB
Arabellastraße 30
81925 München (DE)

(54) **FIRST HOLDING DEVICE, THIRD HOLDING DEVICE, FIFTH HOLDING DEVICE, CONVEYANCE SYSTEM, EXPOSURE SYSTEM, EXPOSURE METHOD, AND METHOD FOR MANUFACTURING DEVICE**

(57) An exposure system is an exposure system capable of exposing a wafer transported from a coating apparatus capable of coating a photosensitive material onto the wafer, including: a holding apparatus which includes a first holding part holding a first surface of the wafer transported from the coating apparatus; a measurement apparatus which includes a first measurement part having at least a first measurement region and capable of measuring a position in a first direction of a second surface on the side opposite to the first surface of the wafer held by the first holding part and a second measurement part having at least one second measurement region different from the first measurement region and capable of measuring a position in the first direction of the first surface or the second surface of the wafer; an exposure apparatus which exposes the wafer with an energy beam; a transport apparatus which transports the wafer from the measurement apparatus to the exposure apparatus; and a control apparatus, wherein the control apparatus determines whether or not the wafer is to be transported toward the exposure apparatus by the transport apparatus based on a measurement result of the first measurement part and a measurement result of the second measurement part.

FIG. 7

# Description

[Technical Field]

The present invention relates to a first holding apparatus, a third holding apparatus, a fifth holding apparatus, a transport system, an exposure system, an exposure method, and a device manufacturing method.

[Background Art]

Conventionally, devices for holding and transporting wafers are known.

[Citation List]

[Patent Document]

[Patent Document 1]
US Patent No. 6852644

[Summary of Invention]

A first aspect of an exposure system of the present invention is an exposure system capable of exposing a wafer transported from a coating apparatus capable of coating a photosensitive material onto the wafer, including: a holding apparatus which includes a first holding part holding a first surface of the wafer transported from the coating apparatus; a measurement apparatus which includes a first measurement part having at least a first measurement region and capable of measuring a position in a first direction of a second surface on the side opposite to the first surface of the wafer held by the first holding part and a second measurement part having at least one second measurement region different from the first measurement region and capable of measuring a position in the first direction of the first surface or the second surface of the wafer; an exposure apparatus which exposes the wafer with an energy beam; a transport apparatus which transports the wafer from the measurement apparatus to the exposure apparatus; and a control apparatus, wherein the control apparatus determines whether or not the wafer is to be transported toward the exposure apparatus by the transport apparatus based on a measurement result of the first measurement part and a measurement result of the second measurement part.

A second aspect of the exposure system of the present invention includes: a measurement apparatus which is able to acquire information on a shape of a wafer; an exposure apparatus which exposes the wafer with an energy beam; a transport apparatus which transports the wafer to the exposure apparatus; and a control apparatus, wherein the control apparatus controls the transporting of the wafer using the transport apparatus based on a measurement result of the measurement apparatus.

A third aspect of the exposure system of the present invention includes: a measurement apparatus which is able to measure information on a shape of a wafer; an exposure apparatus which exposes the wafer with an energy beam; a temperature control apparatus which controls a temperature of the wafer transported to the exposure apparatus; and a control apparatus, wherein the control apparatus controls the temperature of the wafer using the temperature control apparatus based on a measurement result of the measurement apparatus.

A fourth aspect of the exposure system of the present invention includes: a measurement apparatus which is able to acquire information on a shape of a wafer; an exposure apparatus which exposes the wafer with an energy beam; a rotating apparatus which rotates the wafer transported to the exposure apparatus; and a control apparatus, wherein the control apparatus controls a rotational speed or rotational acceleration of the wafer using the rotating apparatus based on a measurement result of the measurement apparatus.

A fifth aspect of the exposure system of the present invention includes: a measurement apparatus which is able to acquire information on a shape of a wafer; an exposure apparatus which exposes the wafer with an energy beam; and a control apparatus, wherein in the exposure apparatus, focus adjustment is performed to adjust a positional relationship between a focal position of the energy beam and a surface of the wafer, and wherein the control apparatus controls the focus adjustment based on a measurement result of the measurement apparatus.

A first aspect of a first holding apparatus of the present invention is a first holding apparatus included in a transport system transporting a wafer, including: a first base in which a first opening is formed in a third surface; a first wall portion which has an annular shape and is provided in the third surface to surround the first opening and protrudes in a first direction intersecting the third surface; and a second wall portion which is provided on the outside of the first wall portion with respect to the first opening in a second direction corresponding to a direction parallel to the third surface and protrudes in the first direction, wherein a height of a tip of the second wall portion in the first direction is lower than a height of a tip of the first wall portion in the first direction, and wherein a gas located between the first base and the wafer is able to be sucked through the first opening.

A first aspect of a transport system of the present invention is a first transport system for transporting a wafer, including: the first holding apparatus according to any of the above; and a second holding apparatus, wherein the second holding apparatus includes a second base in which a second opening is formed in a fourth surface, a third wall portion which has an annular shape and is provided in the fourth surface to surround the second opening and protrudes in the first direction, and a fourth wall portion which is provided on the outside of the third wall portion with respect to the second opening in the second direction and protrudes in the first direction, wherein a height of a tip of the fourth wall portion in the first direction is lower than a height of a tip of the third wall portion in the first direction, and wherein a gas located between the second base and the wafer is able to be sucked through the second opening.

A first aspect of a third holding apparatus of the present invention is a third holding apparatus included in a transport system for transporting a wafer, including: a third opening which is able to suck a gas; a fifth wall portion which has an annular shape and is provided in a fifth surface to surround the third opening and protrudes in a first direction intersecting the fifth surface; and a first protrusion which is provided on the outside of the fifth wall portion with respect to the third opening in a second direction corresponding to a direction parallel to the fifth surface, wherein a height of a tip of the first protrusion in the first direction is lower than a height of a tip of the fifth wall portion in the first direction.

A second aspect of the transport system of the present invention is a transport system for transporting a wafer, including: the third holding apparatus according to any one of the above; and a fourth holding apparatus, wherein the fourth holding apparatus includes a fourth opening which is able to suck a gas, a sixth wall portion which has an annular shape and is provided in a sixth surface to surround the fourth opening and protrudes in a first direction intersecting the sixth surface, and a second protrusion which is provided on the outside of the sixth wall portion with respect to the fourth opening in the second direction, and wherein a height of a tip of the second protrusion in the first direction is lower than a height of a tip of the sixth wall portion in the first direction.

A first aspect of a fifth holding apparatus of the present invention is a fifth holding apparatus included in a transport system for transporting a wafer, including: a second base in which a fifth opening is formed in a seventh surface; a seventh wall portion which has an annular shape and is provided in the seventh surface to surround the fifth opening and protrudes in a first direction intersecting the seventh surface; and a third protrusion which is provided on the seventh wall portion, wherein a height of a tip of the third protrusion in the first direction is higher than a height of a tip of the seventh wall portion in the first direction, and wherein a gas located between the second base and the wafer is able to be sucked.

A third aspect of the transport system of the present invention is a transport system for transporting a wafer, including: the fifth holding apparatus according to any one of the above; sixth and seventh holding apparatuses, wherein the sixth holding apparatus includes a third base in which a sixth opening is formed in an eighth surface, an eighth wall portion which has an annular shape and is provided in the eighth surface to surround the sixth opening and protrudes in the first direction, and a fourth protrusion which is provided on the eighth wall portion, wherein a height of a tip of the fourth protrusion in the first direction is higher than a height of a tip of the eighth wall portion in the first direction, wherein a gas located between the third base and the wafer is able to be sucked, wherein the seventh holding apparatus includes a fourth base in which a seventh opening is formed in a ninth surface, a ninth wall portion which has an annular shape and is provided in the ninth surface to surround the seventh opening and protrudes in the first direction, and a fifth protrusion which is provided on the ninth wall portion, wherein a height of a tip of the fifth protrusion in the first direction is higher than a height of a tip of the ninth wall portion in the first direction, and wherein a gas located between the fourth base and the wafer is able to be sucked.

A sixth aspect of the exposure system of the present invention includes: the transport system according to any one of the above; and an exposure apparatus which exposes a wafer transported using the transport system with an energy beam.

A first aspect of an exposure method of the present invention is an exposure method for exposing a wafer, including: exposing a wafer by exposing the wafer transported by the transport system according to any one of the above to an energy beam.

A first aspect of a device manufacturing method of the present invention is a device manufacturing method including: an exposure step, wherein the exposure step includes exposing the wafer coated with a resist using the exposure system according to any one of the above and developing the exposed wafer.

A second aspect of the device manufacturing method of the present invention is a device manufacturing method including: an exposure step, wherein the exposure step includes exposing the wafer whose surface is coated with a resist using the exposure system according to any one of the above and developing the exposed wafer.

[Brief Description of Drawings]

FIG. 1 is a perspective view of a wafer warped in an umbrella shape and used in a transport system of a first embodiment of the present invention.
FIG. 2 is a perspective view of a wafer warped in a Frisbee shape.
FIG. 3 is a perspective view of a wafer warped in a parabolic shape.
FIG. 4 is a perspective view of a wafer warped in a saddle shape.
FIG. 5 is a plan view schematically showing the transport system.
FIG. 6 is a plan view of a part of a measurement apparatus of the transport system.
FIG. 7 is a cross-sectional view taken along a cutting line A1-A1 of FIG. 6.
FIG. 8 is a cross-sectional front view schematically showing a wafer stage of an exposure apparatus.
FIG. 9 is a plan view of a main part of a transport robot of the transport system.

FIG. 10 is an enlarged view of the main part in FIG. 9.

FIG. 11 is a cross-sectional view taken along a cutting line A2-A2 in FIG. 10.

FIG. 12 is a cross-sectional view corresponding to FIG. 10 in a modified example of the transport system.

FIG. 13 is a cross-sectional view illustrating an operation of a conventional holding apparatus.

FIG. 14 is a diagram showing an example of a change in a warpage amount threshold value with respect to the thickness of the wafer.

FIG. 15 is a plan view of a part of a main part of a transport system of a second embodiment of the present invention.

FIG. 16 is a cross-sectional view taken along a cutting line A4-A4 in FIG. 15.

FIG. 17 is a cross-sectional view of a main part of a transport system of a third embodiment of the present invention.

FIG. 18 is a plan view of a main part of a transport system of a fourth embodiment of the present invention.

FIGS. 19 are cross-sectional views taken along cutting lines A6-A6, A7-A7, and A8-A8 in FIG. 18.

FIG. 20 is a perspective view of a fifth holding apparatus of a transport system.

FIG. 21 is a cross-sectional view illustrating an operation of the fifth holding apparatus.

FIG. 22 is a cross-sectional view illustrating an operation of a conventional holding apparatus.

FIG. 23 is a cross-sectional view illustrating a state in which a wafer that is warped in a downwardly convex shape comes into contact with the holding apparatus.

FIG. 24 is a cross-sectional view illustrating a state in which a wafer that is warped in an upwardly convex shape comes into contact with the holding apparatus.

[Description of Embodiments]

(First embodiment)

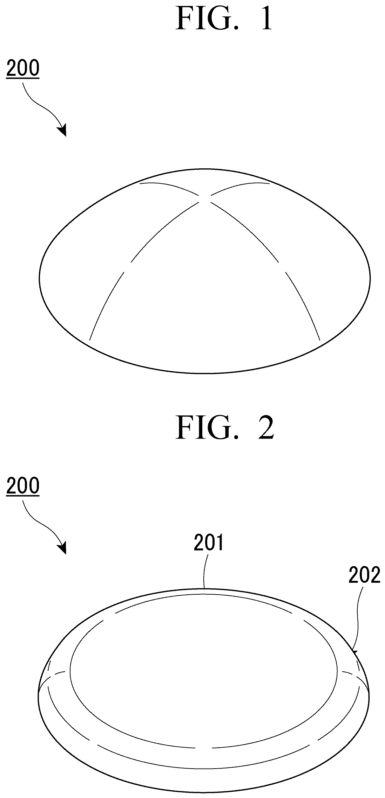

Hereinafter, a first embodiment of the present invention will be described with reference to FIGS. 1 to 13. In the following description, ordinal numbers such as first and second are added for the sake of description, but the ordinal numbers may be omitted or the ordinal numbers may be changed.

Hereinafter, a wafer 200 transported by a transport system to be described later will be described using FIGS. 1 to 4. FIGS. 1 to 4 show the shape of the wafer 200 placed on a horizontal plane as an example. Furthermore, in the figures below, the warpage (curvature) amount of the wafer 200 is shown to be larger than the actual warpage amount.

The wafer 200 in a state without warping has a circular flat plate shape when viewed from above. For example, the diameter of the wafer 200 is 300 mm.

The wafer 200 shown in FIG. 1 is warped in a so-called umbrella shape. The umbrella-shaped wafer 200 has a shape in which the wafer 200 gradually moves downward from the center of the wafer 200 toward the outer edge in plan view.

Furthermore, the warped shape of the wafer 200 is not limited to an umbrella shape.

The wafer 200 shown in FIG. 2 is warped in a so-called Frisbee shape. In the Frisbee-shaped wafer 200, a center portion 201 of the wafer 200 in plan view has an upwardly convex gently sloped portion, and an outer peripheral portion 202 has a steeply sloped portion gradually moving downward. The slope of the outer peripheral portion 202 is steeper than the slope of the center portion 201. Furthermore, the center portion 201 may be flat. The outer peripheral portion 202 of the wafer 200 surrounding the center portion 201 has a shape that gradually moves downward toward the outer edge.

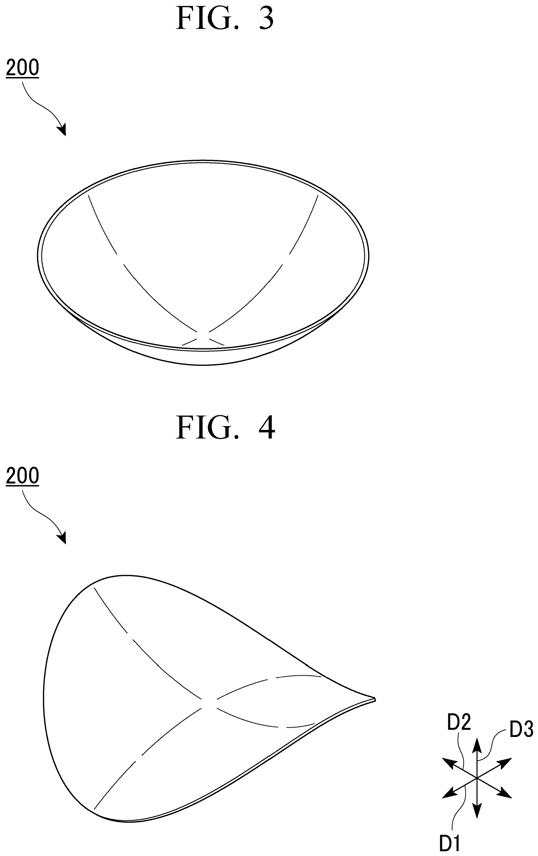

The wafer 200 shown in FIG. 3 is warped in a so-called parabolic shape. The parabolic-shaped wafer 200 has a shape in which the wafer 200 gradually moves upward from the center of the wafer 200 toward the outer edge in plan view.

The wafer 200 shown in FIG. 4 is warped in a so-called saddle shape. Here, directions that are orthogonal to the thickness direction (hereinafter, simply referred to as the thickness direction) D3 of the wafer 200 and that intersect each other are defined as the first orthogonal direction D1 and the second orthogonal direction D2. In FIG. 4, the thickness direction D3 may be a direction orthogonal to the horizontal plane on which the wafer 200 is placed. In the saddle-shaped wafer 200, a portion located in the first orthogonal direction D1 to the center of the wafer 200 in plan view has a shape that gradually moves downward from the center toward the outer edge. The portion located in the second orthogonal direction D2 to the center of the wafer 200 in plan view has a shape that gradually moves upward from the center toward the outer edge.

Next, an exposure system 1 will be described. Furthermore, in the following description, the X and Y axes orthogonal to each other are defined in a plan substantially parallel to the horizontal plane and the Z axis is defined in a direction orthogonal to the X and Y axes. Furthermore, the plane defined by the X and Y axes does not have to be substantially horizontal.

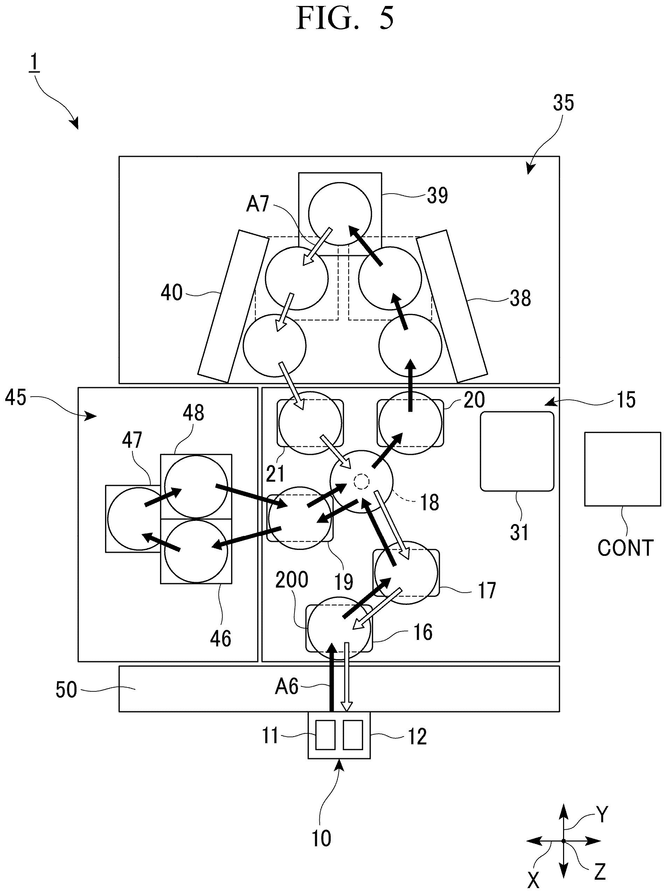

As shown in FIG. 5, the exposure system 1 of this embodiment is a system for exposing the wafer 200. The exposure system 1 includes a transport system 15, an exposure apparatus 35, a measurement station 45, and a control apparatus CONT. Furthermore, the exposure system 1 may not include the measurement station 45.

Furthermore, the circular member in FIG. 5 is the wafer 200, and an example of the moving path of the wafer 200 carried into the exposure system 1 from a

**EP 4 471 501 A1**

coater/developer 10 is shown. A black arrow A6 indicates an example of the moving path of the unexposed wafer 200, and a white arrow A7 indicates an example of the moving path of the exposed wafer 200.

The exposure system 1 is connected to the coater/developer 10 via an interface device 50. The coater/developer 10 includes a coating apparatus 11. The coating apparatus 11 can coat a photosensitive material onto the wafer 200. Furthermore, the wafer 200 coated with a photosensitive material may also be simply referred to as the wafer 200 in the following description. The wafer 200 coated with a photosensitive material is carried from the coater/developer 10 to the exposure apparatus 35 via the transport system 15 to be exposed.

Further, the coater/developer 10 includes a developing apparatus 12 and the wafer 200 exposed by the exposure apparatus 35 is carried from the transport system 15 into the coater/developer 10 and developed by the developing apparatus 12.

The interface device 50 can temporarily hold at least one of the unexposed wafer 200 and the exposed wafer 200 coated with a photosensitive material. Furthermore, the interface device 50 may not be provided.

The transport system 15 includes a measurement apparatus 16, a transport robot 17, a buffer 18, a transport robot 19, a loading robot 20, and an unloading robot 21.

Furthermore, the configuration, arrangement, and the like of the transport system 15 shown in FIG. 5 are merely examples, and some configurations may be omitted. For example, one of the loading robot 20 and the unloading robot 21 may be omitted and one robot may be used for both loading and unloading of the wafer 200.

The measurement apparatus 16 measures the shape of the unexposed wafer 200 coated with a photosensitive material by the coater/developer 10.

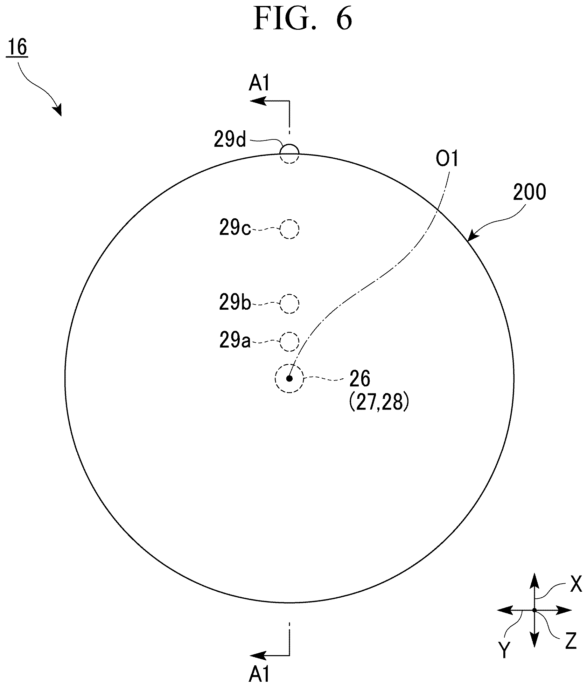

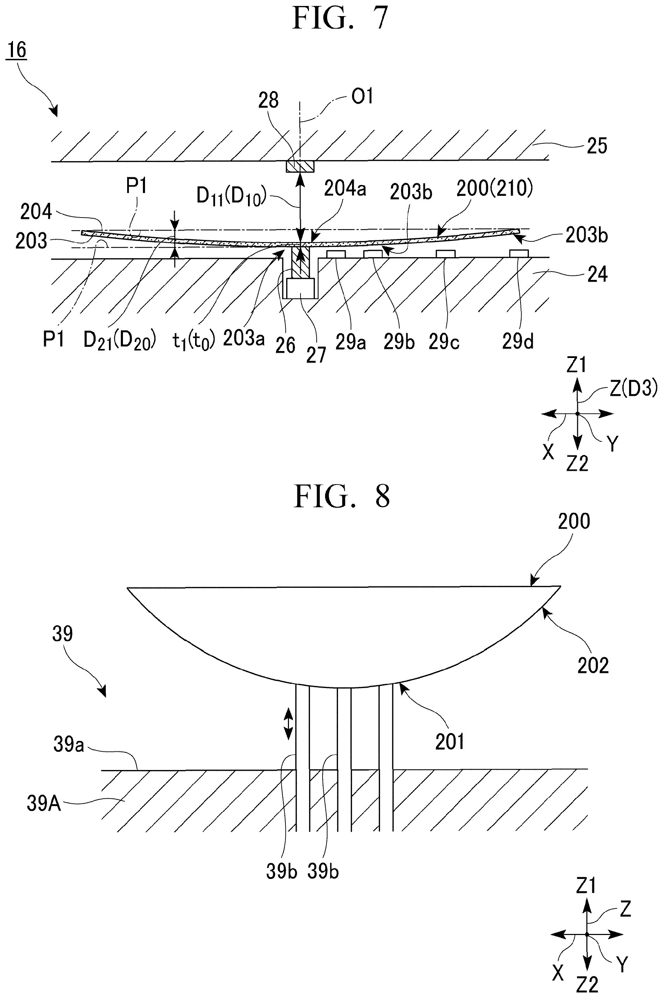

As shown in FIGS. 6 and 7, the measurement apparatus 16 includes a first frame 24, a second frame 25, a holding apparatus 26, a moving part 27, a first measurement part 28, and a plurality of second measurement parts 29a, 29b, 29c, and 29d. The control apparatus CONT also controls the measurement apparatus 16. Furthermore, the frames 24 and 25 are omitted in FIG. 6.

As shown in FIG. 7, the first frame 24 and the second frame 25 are arranged away from each other in the Z-axis direction to face each other.

The holding apparatus 26 is provided in the first frame 24 and holds the wafer carried into the transport system 15. For example, the holding apparatus 26 holds the wafer 200 through suction or the like. The holding apparatus 26 holds a first position 203a of a first surface 203 that faces a first side of the wafer 200 in the thickness direction D3. In this example, the thickness direction D3 is parallel to the Z axis and the first surface 203 of the wafer 200 held by the holding apparatus 26 faces a Z2 side.

Further, a second surface 204 of the wafer 200 held by the holding apparatus 26 faces a second side on the side opposite to the first side of the wafer 200 in the thickness direction D3. That is, the second surface 204 faces a Z1 side to face the frame 25.

The moving part 27 includes, for example, a drive motor (not shown). The moving part 27 rotates, for example, the holding apparatus 26 about a first axis O1 to rotate the wafer 200 about the first axis O1 intersecting the first surface 203 of the wafer 200. In this example, the first axis O1 is parallel to the Z axis.

The first measurement part 28 is fixed to the second frame 25 to face the holding apparatus 26. For example, the first measurement part 28 includes a capacitance sensor. The first measurement part 28 can measure the position in the thickness direction D3 of a second position 204a in the wafer 200 held by the holding apparatus 26. In this example, the second position 204a is located within the second surface 204 on the side opposite to the first surface 203 of the wafer 200.

In this example, the first surface 203 of the wafer 200 is the surface of the photosensitive material, but may also be the surface of another material coated on the photosensitive material. The first position 203a and the second position 204a are located on the first axis O1 and are approximately at the center of the wafer 200.

The second measurement parts 29a to 29d are fixed to the first frame 24. As shown in FIG. 6, the second measurement parts 29a to 29d are arranged on the same straight line passing through the first axis O1. In this example, the second measurement parts 29a to 29d are arranged along the X axis.

Furthermore, the second measurement parts 29a to 29d may not be arranged on the same straight line passing through the first axis O1. All of the second measurement parts 29a to 29d may be fixed to the second frame 25 or a part of the second measurement parts 29a to 29d may be fixed to the first frame 24 and the remaining part of the second measurement parts 29a to 29d may be fixed to the second frame 25.

The distances between the second measurement parts 29a to 29d and the first axis O1 are different. The second measurement parts 29a to 29d are arranged in the order of the second measurement parts 29a, 29b, 29c, and 29d, in the radial and outward direction of the wafer 200, as the distance from the first axis O1 increases. In this example, the second measurement parts 29a to 29d are arranged so that the distance between the second measurement parts 29c and 29d on the radially outer side of the wafer 200 is larger than the distance between the second measurement parts 29a and 29b on the radially inner side, but may be arranged at the same intervals.

For example, the second measurement parts 29a to 29d include capacitance sensors. Furthermore, the first measurement part 28 and the second measurement parts 29a to 29d are not limited to capacitance sensors, but may be inductive sensors or the like or may be optical sensors including light receiving units. Further, the first measurement part 28 and the second measurement parts 29a to 29d may be different types of sensors.

As shown in FIG. 7, the second measurement parts 29a to 29d can measure the position in the thickness direction D3 (Z-axis direction) in each third position 203b on the outer peripheral side of the second position 204a in the radial direction of the wafer 200 in the first surface 203 of the wafer 200. Each of the second measurement parts 29a to 29d can measure the position in the thickness direction D3 of the plurality of positions in the circumferential direction of the wafer 200 rotated about the first axis O1 by the moving part 27.

Furthermore, the number of second measurement parts included in the measurement apparatus 16 may be one to three or five or more.

The control apparatus CONT is connected to the exposure system 1 and controls the operations of the transport system 15, the exposure apparatus 35, and the like. The control apparatus CONT includes a CPU (Central Processing Unit), a memory, and the like. The memory stores a control program or the like that controls the CPU. The CPU is operated based on the control program.

In order to measure the shape of the wafer 200 (for example, the thickness and the warpage amount), a reference wafer 210 whose thickness $t_0$ and warpage amount $w_0$ are known in advance may be used. For example, the outer diameter and thickness $t_0$ of the reference wafer 210 are approximately the same as the outer diameter and thickness $t_1$ of the wafer 200.

In this case, the memory of the control apparatus CONT stores the thickness $t_0$, the warpage amount $w_0$, the distance $D_{10}$ described later, the flatness $D_{20}$, and the like.

The control apparatus CONT measures the thickness of the wafer 200 (acquires information on the thickness of the wafer 200) based on the measurement result of the reference wafer 210 by the first measurement part 28 and the measurement result of the wafer 200 by the first measurement part 28. Specifically, for example, the distance (measurement result) to a second position 204a of the wafer 200 by the first measurement part 28 is defined as the distance $D_{11}$. The distance to a second position 204a of the reference wafer 210 by the first measurement part 28 is defined as the distance $D_{10}$.

At this time, for example, the thickness $t_i$ of the wafer 200 is obtained from formula (1).

$$t_1=t_0-(D_{11}-D_{10}) \ \ldots \ (1)$$

The control apparatus CONT measures the warpage amount of the wafer 200 (acquires information on the warpage amount of the wafer 200) based on the measurement result of the reference wafer 210 by the first measurement part 28 and the second measurement parts 29a to 29d and the measurement result of the wafer 200 by the first measurement part 28 and the second measurement parts 29a to 29d.

For example, the warpage amount of the wafer 200 is obtained as below. The distance between a pair of planes P1 when the wafer 200 is disposed between the pair of planes P1 arranged in parallel is defined as the flatness $D_{21}$. The flatness $D_{21}$ is obtained from the measurement result of the first measurement part 28 and the second measurement parts 29a to 29d.

The flatness $D_{20}$ with respect to the reference wafer 210 is obtained in advance. The warpage amount $w_0$ of the reference wafer 210 is obtained from the formula of $(D_{20}-t_0)$. At this time, for example, the warpage amount $w_1$ of the wafer 200 is obtained from formula (2).

$$w_1=w_0+(D_{21}-D_{20}) \ \ldots \ (2)$$

The transport robot 17 is a robot that moves the wafer 200 between the measurement apparatus 16 and the buffer 18.

The buffer 18 is a device that temporarily stores the wafer 200.

The transport robot 19 is a robot that exchanges the wafer 200 between the transport system 15 and the measurement station 45.

The loading robot 20 is a robot that carries out the wafer 200 from the buffer 18 and delivers the unexposed wafer 200 to the exposure apparatus 35.

The unloading robot 21 is a robot that receives the exposed wafer 200 from the exposure apparatus 35 and delivers the wafer to the buffer 18.

A removable carrier (for example, FOUP: Front-Opening Unified Pod) 31 is disposed within the transport system 15. The carrier 31 is used for transporting and storing the wafer 200. The loading robot 20 can transport the wafer 200 from the buffer 18 to the carrier 31.

The exposure apparatus 35 exposes the wafer 200 with an energy beam. The exposure apparatus 35 includes a loading slider 38, a wafer stage 39, an unloading slider 40, and a beam irradiation system (not shown).

The wafer stage 39 is a stage on which the wafer 200 is placed. As shown in FIG. 8, for example, the wafer stage 39 includes a holder 39A and a plurality of movable pins 39b.

A wafer holding surface 39a of the holder 39A is a plane and is parallel to the surface d defined by the x and y axes in FIG. 8. Furthermore, in FIG. 8, a plurality of protrusions (not shown) are formed on the upper surface of the holder 39A, and the wafer holding surface 39a is defined by the upper end portions of the plurality of protrusions.

The plurality of movable pins 39b can move in the vertical direction (Z-axis direction) with respect to the holder 39A (wafer holding surface 39a). The plurality of movable pins 39b support the center portion 201 of the wafer 200 from below the center portion 201. When the wafer stage 39 moves to the loading position (the dotted rectangular position near the loading slider 38 in FIG. 5), the plurality of movable pins 39b rise and receive the unexposed wafer from the loading slider 38. FIG. 8 shows this state.

When the plurality of movable pins 39b receive the wafer 200, the plurality of movable pins are lowered to place the wafer 200 on the holder 39A (wafer holding surface 39a). The holder 39A discharges a gas (for example, a gas) in a space between the wafer 200 and the holder 39A through a plurality of intake holes (not shown) formed in the upper surface thereof so that almost the entire surface of the wafer 200 is sucked along the wafer holding surface 39a to hold the wafer 200.

Even when the wafer 200 has a warped shape as shown in FIG. 8, the wafer 200 can be held in a substantially flat shape on the wafer holding surface 39a by the suction force generated by the gas discharge described above if the warped shape (warpage amount) is within the allowable range. The wafer 200 held by the holder 39A is exposed on the wafer stage 39 with an energy beam from a beam irradiation system (not shown).

When the exposure of the wafer 200 is completed and the wafer stage 39 moves to the unload position (the position indicated by a dotted rectangle near the unloading slider 40 in FIG. 5), the discharge (suction) of the holder 39A is stopped, and as the plurality of movable pins 39b rise, the wafer 200 also moves upward away from the holding surface.

The unloading slider 40 carries out the wafer 200 supported by the plurality of movable pins 39b from the wafer stage 39.

The measurement station 45 includes a loading apparatus 46, a wafer stage 47, and an unloading apparatus 48.

The loading apparatus 46 delivers the wafer 200 received from the transport robot 19 of the transport system 15 to the wafer stage 47.

The wafer stage 47 is a movable stage which is provided in the measurement station 45 and on which the wafer 200 is placed. The measurement station 45 includes a mark detection device (not shown) and the like.

The unloading apparatus 48 receives the wafer 200 from the wafer stage 47. The transport robot 19 of the transport system 15 receives the wafer 200 from the unloading apparatus 48 and carries out the wafer 200 from the measurement station 45.

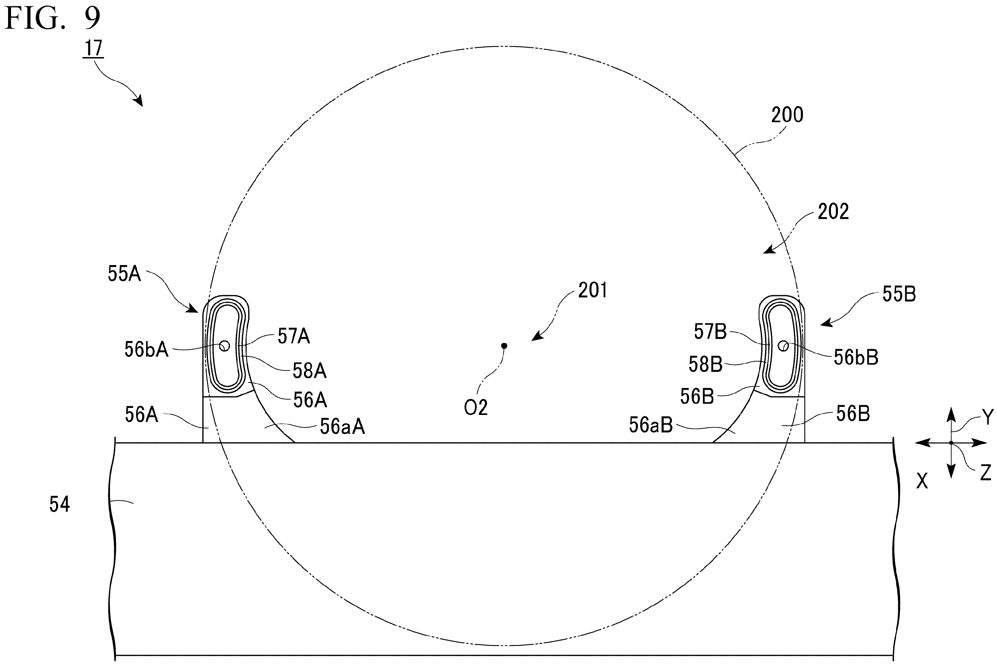

Next, as shown in FIG. 9, for example, a first holding apparatus 55A and a second holding apparatus 55B used in the transport robot 17 of the transport system 15 or the like will be described. The first holding apparatus 55A and the second holding apparatus 55B are included in the transport system 15 and are included in the exposure system 1.

The transport robot 17 is equipped with (includes) a holding frame 54, the first holding apparatus 55A, and the second holding apparatus 55B.

As shown in FIGS. 9 to 11, the first holding apparatus 55A includes a first base 56A, a first wall portion 57A, and a second wall portion 58A.

For example, the first base 56A has a flat plate shape and is disposed along a horizontal plane. A first opening 56bA is formed in a third surface 56aA which is the upper surface of the first base 56A.

A discharge hole 56cA is formed in the first base 56A. One end of the discharge hole 56cA is connected to the first opening 56bA. The discharge hole 56cA extends along the third surface 56aA within the first base 56A. The other end of the discharge hole 56cA is connected to a suction apparatus Vac1.

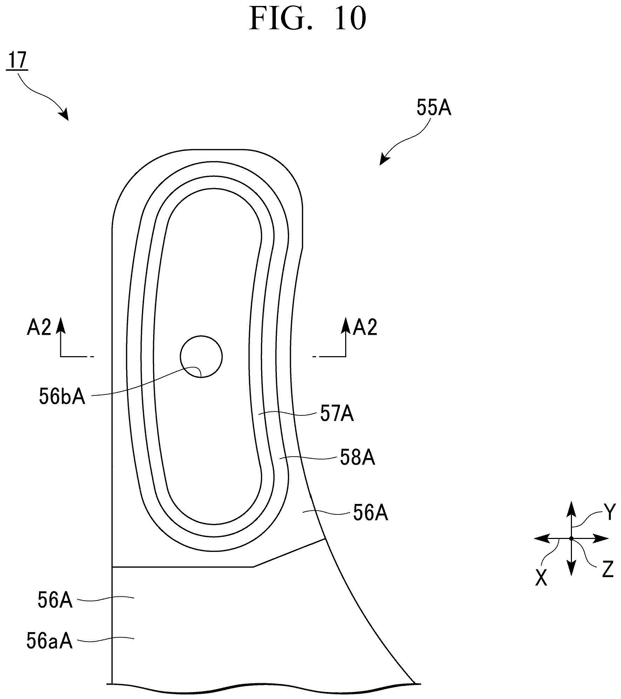

As shown in FIGS. 9 and 10, the first wall portion 57A is formed in an annular shape. More specifically, the first wall portion is formed in an annular shape so that a region surrounded by the first wall portion 57A has an elongated oval shape. As shown in FIG. 9, a region surrounded by the first wall portion 57A is disposed along the outer peripheral portion 202 of the wafer 200.

As shown in FIGS. 9 to 11, the first wall portion 57A is provided in the third surface 56aA to surround the first opening 56bA. The first wall portion 57A protrudes toward the Z1 side (hereinafter, also simply referred to as the first side Z1) in the first direction Z (Z-axis direction) intersecting the third surface 56aA more than the first base 56A. Here, one of the directions parallel to the third surface 56aA is defined as a second direction (X-axis direction).

As shown in FIGS. 9 and 10, the first opening 56bA is formed in the middle part in the long axis direction (Y-axis direction) of the region surrounded by the first wall portion 57A. The diameter of the first opening 56bA in the Y-axis direction may be larger than the diameter of the first opening 56bA in the X-axis direction, but as shown in FIGS. 9 and 10, the diameter of the first opening 56bA in the Y-axis direction may be approximately the same as the diameter of the first opening 56bA in the X-axis direction.

While the transport robot 17 is holding the wafer 200, at least a part of the first wall portion 57A contacts the wafer 200.

As shown in FIGS. 9 to 11, the second wall portion 58A is provided on the outside of the first wall portion 57A with respect to the first opening 56bA. The second wall portion 58A is provided on the third surface 56aA at a radially outer side of the first opening 56bA than the first wall portion 57A. The second wall portion 58A is provided to surround the first wall portion 57A. The second wall portion 58A protrudes from the third surface 56aA toward the first side Z1. In this example, in the second wall portion 58A, the inner side surface of the second wall portion 58A contacts the outer side surface of the first wall portion 57A over the entire circumference of the first wall portion 57A.

The first base 56A protrudes outward in the radial direction of the first opening 56bA more than the second wall portion 58A.

The height of the tip (upper surface) on the first side Z1 of the second wall portion 58A is lower than the height of the tip (upper surface) on the first side Z1 of the first wall portion 57A. That is, the tip on the first side Z1 of the second wall portion 58A is located closer to the second side Z2 (hereinafter, also simply referred to as the second side Z2) on the side opposite to the first side Z1 in the first direction (Z-axis direction) than the tip on the first side Z1 of the first wall portion 57A.

For example, the difference in height between the first wall portion 57A and the second wall portion 58A is from several hundred µm (micrometers) to several thousand µm. For example, the difference in height between the first wall portion 57A and the second wall portion 58A may be 300 µm to 1000 µm.

The second wall portion 58A is thicker than the first wall portion 57A in a surface parallel to the plane defined by the X and Y axes. For example, the length of the second wall portion 58A in the second direction X is longer than the length of the first wall portion 57A in the second direction X.

The first base 56A, the first wall portion 57A, and the second wall portion 58A that constitute the first holding apparatus 55A are integrally formed of ceramics or the like.

As shown in FIG. 9, the first base 56A of the first holding apparatus 55A is movably supported by the holding frame 54.

When the suction apparatus Vac1 is operated, a gas located between the first base 56A and the wafer 200 can be sucked through the discharge hole 56cA and the first opening 56bA.

As shown in FIG. 9, the second holding apparatus 55B is configured similarly to the first holding apparatus 55A. The second holding apparatus 55B includes a second base 56B provided similarly to the first base 56A, a third wall portion 57B provided similarly to the first wall portion 57A, and a fourth wall portion 58B provided similarly to the second wall portion 58A.

For example, the second base 56B has a flat plate shape and is disposed along a horizontal plane. A second opening 56bB is formed in a fourth surface 56aB which is the upper surface of the second base 56B.

A discharge hole (not shown) is formed in the second base 56B.

The third wall portion 57B is formed in an annular shape. The third wall portion 57B is disposed so that a region surrounded by the third wall portion 57B is formed in an elongated oval shape. The third wall portion 57B is provided in the fourth surface 56aB to surround the second opening 56bB. The third wall portion 57B protrudes toward the first side Z1 more than the second base 66A.

As shown in FIG. 9, the second opening 56bB is formed in the middle part in the long axis direction (Y-axis direction) of the region surrounded by the second wall portion 58A. As shown in FIG. 9, the diameter of the second opening 56bB in the Y-axis direction may be approximately the same as the diameter of the second opening 56bB in the X-axis direction (second direction) or may be larger than the diameter of the second opening 56bB in the X-axis direction (second direction).

The fourth wall portion 58B is provided on the outside of the third wall portion 57B with respect to the second opening 56bB. The fourth wall portion 58B is provided on the radially outer side of the second opening 56bB more than the third wall portion 57B in the fourth surface 56aB. The fourth wall portion 58B is provided to surround the third wall portion 57B. The fourth wall portion 58B protrudes from the fourth surface 56aB toward the first side Z1. The inner side surface of the fourth wall portion 58B contacts the outer side surface of the third wall portion 57Bover the entire circumference of the third wall portion 57B.

The height of the tip (upper surface) on the first side Z1 of the fourth wall portion 58B is lower than the height of the tip (upper surface) on the first side Z1 of the third wall portion 57B. That is, the tip on the first side Z1 of the fourth wall portion 58B is located closer to the second side Z2 than the tip on the first side Z1 of the third wall portion 57B.

Furthermore, the difference in height between the third wall portion 57B and the fourth wall portion 58B is from several hundred µm (micrometers) to several thousand µm. For example, the difference in height may be 300µm to 1000µm.

In the plane parallel to the plane defined by the X and Y axes, the fourth wall portion 58B is thicker than the third wall portion 57B. For example, the length of the fourth wall portion 58B in the second direction X (X-axis direction) is longer than the length of the third wall portion 57B in the second direction X.

The second holding apparatus 55B is formed of the same material as the first holding apparatus 55A.

As shown in FIG. 9, the second base 56B of the second holding apparatus 55B is movably supported by the holding frame 54.

A gas located between the second base 56B and the wafer 200 can be sucked through the second opening 56bB.

Furthermore, in this example, the wall portions (58A, 58B) are continuously formed to surround the entire circumference of the wall portions (57A, 57B), but may be intermittently formed to surround the wall portions (57A, 57B) or may be provided only in a part of the circumference of the wall portions (57A, 57B) (for example, only on the +X-axis direction side of the first wall portion 57A or only on the -X-axis direction side of the third wall portion 57B).

As shown in FIG. 9, the first holding apparatus 55A and the second holding apparatus 55B have a symmetrical shape with respect to a second axis 02 perpendicular to the third surface 56aA and the fourth surface 56aB, respectively. Furthermore, the second axis 02 may be perpendicular to the third surface 56aA or the fourth surface 56aB.

In other words, the first holding apparatus 55A and the second holding apparatus 55B are plane symmetrical with respect to a reference plane that is orthogonal to the facing direction in which the first holding apparatus 55A and the second holding apparatus 55B face each other.

Further, in other words, the first holding apparatus 55A and the second holding apparatus 55Bare arranged at symmetrical positions with respect to the second axis 02. The first holding apparatus 55A and the second holding apparatus 55B are arranged to face each other with the wafer 200 interposed therebetween. Furthermore, in this example, the second axis 02 is parallel to the Z axis.

Furthermore, the first holding apparatus 55A and the second holding apparatus 55Bmay have a symmetrical shape with respect to the axis parallel to the third surface 56aA or the fourth surface 56aB. In other words, the first holding apparatus 55A and the second holding apparatus 55B may be arranged at symmetrical positions with respect to the axis parallel to the third surface 56aA or the fourth surface 56aB. Furthermore, the axis parallel to the third surface 56aA or the fourth surface 56aB is an axis that passes through the second axis 02 and is parallel to the Y axis.

As shown in FIG. 9, the first holding apparatus 55A holds a part of the outer peripheral portion 202 of the wafer 200. The second holding apparatus 55B holds a part of the outer peripheral portion 202 of the wafer 200 different from the above-described part.

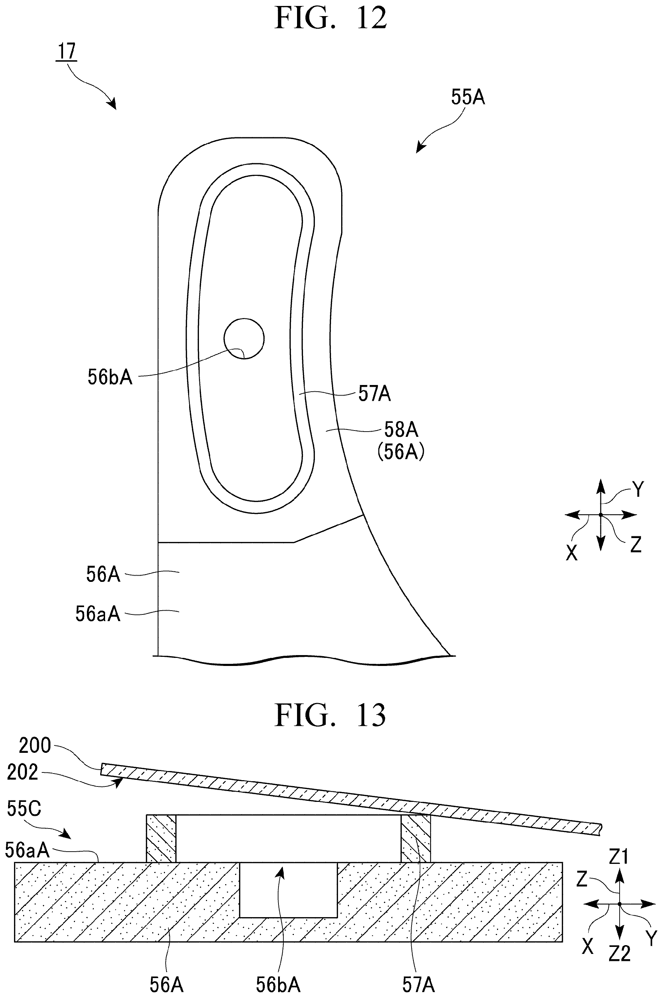

Furthermore, as shown in FIG. 12, the outer end of the first base 56A and the outer end of the second wall portion 58A may be arranged at the same position as each other in the radial direction of the first opening 56bA. Similarly, in the plane defined by the X and Y axes, the outer end of the second base 56B and the outer end of the fourth wall portion 58B may be formed at the same position.

Further, the holding apparatuses 55A and 55B of the transport robot 17 have been described so far, but at least one of the transport robot 19, the loading robot 20, and the unloading robot 21 may include the holding apparatuses 55A and 55B.

Next, the operation of the exposure system 1 with the above-described configuration will be described by focusing on the transport system 15.

The unexposed wafer 200 coated with a photosensitive material by the coating apparatus 11 is transported from the coater/developer 10 to the transport system 15 through the interface device 50. Thereafter, the shape (thickness $t_1$, warpage amount $w_1$, and the like) of the wafer 200 is measured by the measurement apparatus 16.

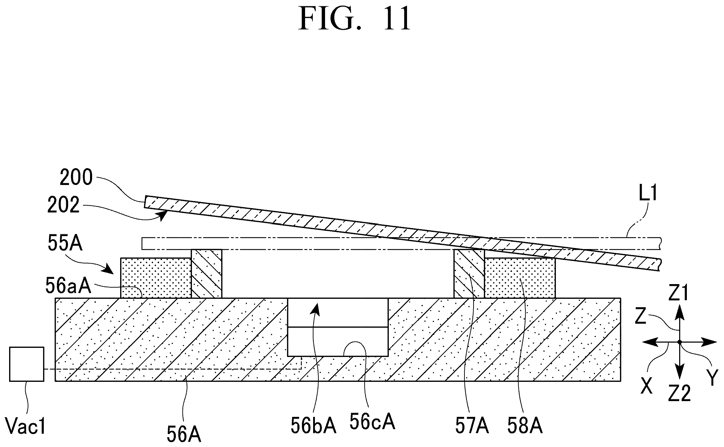

When the measurement of the wafer 200 in the measurement apparatus 16 is completed, the transport robot 17 holds the wafer 200 and carries out the wafer 200 from the measurement apparatus 16. For example, it is assumed that the wafer 200 is warped in a parabolic shape as shown in FIG. 11 when the wafer 200 is held by the holding apparatuses 55A and 55B of the transport robot 17.

The second wall portion 58A is provided on the outside of the first wall portion 57A. Therefore, when the suction apparatus is operated, the distance between the first base 56A (second wall portion 58A) and the wafer 200 around the first wall portion 57Abecomes narrower than the case in which the second wall portion 58A is not provided and a gas becomes difficult to flow into the first wall portion 57Athrough the space between them. Accordingly, the degree of vacuum in the region (space) surrounded by the first wall portion 57A is likely to decrease, and the suction force (wafer holding force) of the first holding apparatus 55A can be increased. Therefore, as indicated by a two-dot chain line L1 in FIG. 11, a part of the outer peripheral portion 202 of the wafer 200 is held by the first wall portion 57A of the first holding apparatus 55A. Similarly, a part of the outer peripheral portion 202 of the wafer 200 different from the above-described part is held by the third wall portion 57B of the second holding apparatus 55B.

Here, a conventional holding apparatus 55C will be described by using FIG. 13. The holding apparatus 55C does not include the second wall portion 58A differently from the first holding apparatus 55A.

Therefore, since the distance between the first base 56A and the wafer 200 on the outside of the first wall portion57A is relatively wide, a gas easily flows into the first wall portion57A through the space between them. Therefore, the outer peripheral portion 202 of the wafer 200 is difficult to be held by the first wall portion 57A of the holding apparatus 55C.

When the transport robot 17moves the wafer 200 to a predetermined position and stops the operation of the suction apparatus Vac1, the holding of the wafer 200 by the holding apparatuses 55A and 55B is released. The wafer 200 is moved from the transport robot 17 to the buffer 18.

As indicated by an arrow A6 in FIG. 5, the transport robot 19 takes out the unexposed wafer 200 from the buffer 18 and delivers the wafer to the loading apparatus 46of the measurement station 45. The loading apparatus 46 delivers the wafer 200 to the wafer stage 47. The measurement station 45performs a measurement process on the wafer 200 held on the wafer stage 47, such as detecting alignment marks on the wafer 200 using a mark detection device.

The measured wafer 200 is moved from the wafer stage 47 to the unloading apparatus 48 and is carried out from the measurement station 45 by the transport robot 19 receiving the wafer 200 from the unloading apparatus 48.

The transport robot 19 delivers the wafer 200 carried out from the measurement station 45 to the buffer 18.

The loading robot 20 delivers the wafer 200 from the buffer 18 to the loading slider 38 of the exposure apparatus 35 and the wafer 200 is transported from the loading slider 38 to the wafer stage 39.

On the wafer stage 39, the wafer 200 is exposed to an energy beam.

As indicated by a white arrow A7 in FIG. 5, the unloading slider 40 carries out the exposed wafer 200 from the wafer stage 39.

The unloading robot 21 of the transport system 15 receives the wafer 200 and delivers the wafer to the buffer 18.

The transport robot 17 moves the exposed wafer 200 to the measurement apparatus 16 and the exposed wafer 200 is carried out from the transport system 15 (exposure system 1). Furthermore, the transport robot 17 may move the wafer 200 to a table located at a position different from the measurement apparatus 16, and the exposed wafer 200 may be carried out from the table.

The exposed wafer 200 is sent to the developing apparatus 12 of the coater/developer 10 through the interface device 50. The developing apparatus 12 develops the wafer 200. The developed wafer 200 is carried out from the coater/developer 10.

Through the above-described steps, the exposure process of the wafer 200 and the development process of the exposed wafer 200in the semiconductor device manufacturing process are completed.

Furthermore, an exposure method of this embodiment is a method for exposing the wafer 200. This exposure method includes exposing the wafer 200 by irradiating the wafer 200 transported to the exposure apparatus 35 with an energy beam by the transport system 15.

As described above, in the first holding apparatus 55A of this embodiment, the height of the tip of the second wall portion 58A in the first direction Z is lower than the height of the tip of the first wall portion 57A in the first direction Z. Therefore, since the distance to the wafer 200 on the outside of the first wall portion 57A is relatively narrow compared to the case in which the second wall portion 58A is not provided in the first holding apparatus 55A, a gas becomes difficult to flow into the first wall portion 57A through the outside of the first wall portion 57A. Therefore, the outer peripheral portion 202 of the wafer 200 can be reliably held by the first wall portion 57A through suction.

Furthermore, the first holding apparatus 55A may hold the center portion 201 of the wafer 200.

There is a case in which the length of the second wall portion 58A in the second direction X is longer than the length of the first wall portion 57A in the second direction X. In this case, a gas becomes difficult to flow between the second wall portion 58A and the wafer 200 and the outer peripheral portion 202 of the wafer 200can be held more reliably by the first wall portion 57A through suction.

The first wall portion is disposed so that a region surrounded by the first wall portion 57A has an elongated oval shape and the first opening 56bA is formed at the middle part of the first wall portion 57A in the long axis direction. Therefore, the pressure loss of the gas flowing inside the first wall portion 57A can be reduced compared to the case in which the first opening 56bA is formed at the end portion of the first wall portion 57A in the long axis direction.

There is a case in which the diameter of the first opening 56bA in the long axis direction of the first wall portion 57A is larger than the diameter of the first opening 56bA in the short axis direction of the first wall portion 57A. In this case, the first opening 56bA has a shape along the first wall portion 57A having an elongated oval shape and the first opening 56bA can be efficiently disposed within the first wall portion 57A.

At least a part of the first wall portion 57A contacts the wafer 200. Therefore, the outer peripheral portion 202 of the wafer 200 can be held by the first wall portion 57A through suction.

Further, the transport system 15 of this embodiment includes the first holding apparatus 55A and the second holding apparatus 55B. In the second holding apparatus 55B, the height of the tip of the fourth wall portion 58B in the first direction Z is lower than the height of the tip of the third wall portion 57B in the first direction Z. Therefore, since the distance to the wafer 200 on the outside of the third wall portion 57B is relatively narrow compared to the case in which the fourth wall portion 58B is not provided in the second holding apparatus 55B, a gas becomes difficult to flow into the third wall portion 57B through the outside of the third wall portion 57B. Therefore, the outer peripheral portion 202 of the wafer 200 can be reliably held by the third wall portion 57B through suction.

Furthermore, also in the second holding apparatus 55B, the outer peripheral portion 202 of the wafer 200 can be reliably held by the third wall portion 57B through suction.

The first holding apparatus 55A and the second holding apparatus 55Bhave a symmetrical shape with respect to the second axis 02. Accordingly, a plurality of parts of the wafer 200 can be held by the first holding apparatus 55A and the second holding apparatus 55B.

The first holding apparatus 55A and the second holding apparatus 55B are arranged at symmetrical positions with respect to the second axis 02. Therefore, a plurality of parts of the wafer 200 can be held by the first holding apparatus 55A and the second holding apparatus 55B.

Further, the measurement apparatus 16 of this embodiment includes the first measurement part 28 and the second measurement parts 29a to 29d. Therefore, the first measurement part 28 can measure the position of the second position 204a in the thickness direction D3 while the wafer 200 is held by the holding apparatus 26. Furthermore, the second measurement parts 29a to 29d can measure the position in the thickness direction D3 of the third position 203b on the outer peripheral side in relation to the second position 204a in the radial direction of the wafer 200 in the first surface 203 of the wafer 200.

The measurement apparatus 16 includes the moving part 27. Accordingly, the wafer 200 can be rotated about the first axis O1.

In general, in a warped wafer, the displacement amount in the thickness direction (also referred to as the warpage amount, deformation amount, or deflection amount) tends to increase toward the outside in the radial direction, but the displacement of the outer peripheral portion 202 of the wafer 200 can be measured with high accuracy using the second measurement parts 29c and 29d.

In consideration of the warpage of the wafer 200, the holding apparatuses 55A and 55B may hold the wafer 200 on the side of the center portion 201 in which the displacement amount in the thickness direction is relatively small.

The first position 203a and the second position 204a are located on the first axis O1 and the second position 204a is located on the second surface 204. Therefore, the first measurement part 28 can measure the position in the thickness direction D3 of the second surface 204 (for example, a region including the center) on the first axis O1 which is the rotation center of the wafer 200.

The control apparatus CONT measures the thickness of the wafer 200 based on the measurement result of the reference wafer 210 by the first measurement part 28 and the measurement result of the wafer 200 by the first measurement part 28. The control apparatus CONT measures the warpage amount of the wafer 200 based on the measurement result of the reference wafer 210 by the first measurement part 28 and the second measurement parts 29a to 29d and the measurement result of the wafer 200 by the first measurement part 28 and the second measurement parts 29a to 29d. In this way, the thickness and the warpage amount of the wafer 200 can be easily measured by using the reference wafer 210.

Furthermore, the control apparatus CONT may store information such as the thickness of the reference wafer 210 without measuring the reference wafer 210 and the shape (thickness and warpage amount) of the wafer 200 may be obtained based on this information and the measurement result of the wafer 200 by the measurement apparatus 16.

The first measurement part 28 includes a capacitance sensor. Therefore, the position of the second position 204a in the thickness direction D3 can be measured with high accuracy.

The second measurement parts 29a to 29d include capacitance sensors. Therefore, the position of the third position 203b in the thickness direction D3 can be measured with high accuracy.

The first measurement part 28 can measure the second position 204a of the second surface 204 and the second measurement parts 29a to 29d can measure the third position 203b of the first surface 203. Both measurement parts 28, 29a to 29d can measure positions on both sides of the wafer 200 in the thickness direction D3.

Further, the exposure system 1 of this embodiment includes the transport system 15 and the exposure apparatus 35. Accordingly, an exposure system can be configured using the transport system 15 that can reliably hold the outer peripheral portion 202 of the wafer 200 by the wall portions 57A and 57B through suction.

Further, the exposure method of this embodiment includes exposing the wafer 200 transported by the transport system 15 by irradiating the wafer 200 with an energy beam. According to the exposure method of this embodiment, even when the wafer 200 has a large deformation such as a warpage amount, the wafer 200 can be reliably held and transported, and the transported wafer 200 can be exposed to an energy beam.

Furthermore, when the warpage amount wi of the wafer 200 measured in the measurement apparatus 16 is equal to or larger than a predetermined warpage amount threshold value, the wafer 200 may be returned (rejected) to the interface device 50 or may be transported (rejected) to the carrier 31 without being transported to the exposure apparatus 35 using the transport robot 17 and the loading robot 20. Furthermore, the warpage amount threshold value may be changed based on the thickness or the like of the wafer 200. In this case, the thickness of the wafer 200 for determining the threshold value may be determined by using the measurement result of the measurement apparatus 16 or using the thickness information of the wafer 200 received in advance from a host computer that manages the exposure system 1 or the like.

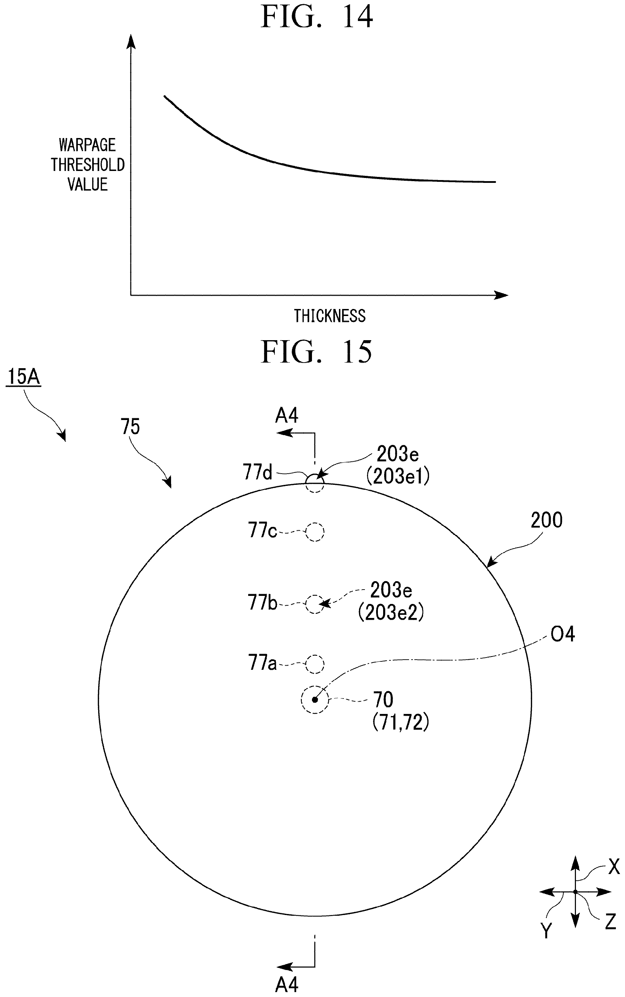

As shown in FIG. 14, for example, the warpage amount threshold value may gradually decrease as the thickness of the wafer 200 increases.

Furthermore, shape measurement (warpage amount measurement and the like) of the wafer 200 by the measurement apparatus 16 does not have to be performed on all wafers 200 that are carried into the exposure system 1. For example, since manufacturing is often managed using a predetermined number (for example, 25) of wafers 200 as one lot in the semiconductor device manufacturing process, the shape of only some (one or more) wafers 200 in one lot may be measured by the measurement apparatus 16 and the shapes of the remaining wafers 200 in the lot may be measured using the measurement result of some of the wafers 200.

Furthermore, the lengths of the second wall portion 58A and the fourth wall portion 58B in the second direction X may be equal to or shorter than the lengths of the first wall portion 57A and the third wall portion 57B in the second direction X.

The first opening 56bA and the second opening 56bB may be respectively formed at the end portions of the first wall portion 57A and the third wall portion 57B in the long axis direction. A region surrounded by the first wall portion 57A and a region surrounded by the third wall portion 57B may each have a circular shape, a polygonal shape, or the like.

The diameter of the first opening 56bA in the long axis direction of the first wall portion 57A and the diameter of the second opening 56bB in the long axis direction of the third wall portion 57B may be respectively equal to or smaller than the diameter of the first wall portion 57A in the short axis direction and the diameter of the third wall portion 57B in the short axis direction.

The first holding apparatus 55A and the second holding apparatus 55B may have an asymmetrical shape about the second axis 02. That is, the first holding apparatus 55A and the second holding apparatus 55B may be arranged at asymmetrical positions with respect to the second axis 02.

The measurement apparatus 16 may not include the frames 24 and 25 and the moving part 27.

The first position 203a and the second position 204a may not be located on the first axis O1. The second position 204a may be located on the first surface 203.

(Second embodiment)

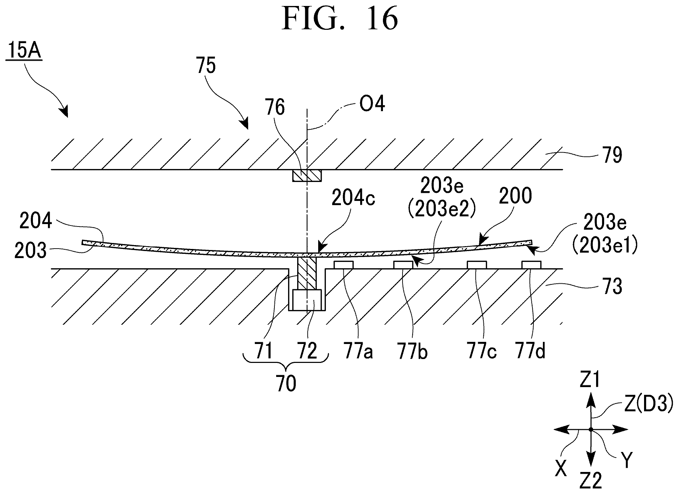

Next, a second embodiment of the present invention will be described with reference to FIGS. 15 and 16, but the same parts as in the above-described embodiment are indicated by the same reference numerals and the description thereof will be omitted.

As shown in FIGS. 15 and 16, a transport system 15A of the exposure system 1 of this embodiment is different from that of the first embodiment in that a measurement apparatus 75 is provided instead of the measurement apparatus 16. Even in the second embodiment, the control apparatus CONT controls the measurement apparatus 75.

The measurement apparatus 75 can also acquire information on the shape of the wafer. The measurement apparatus 75 includes a first measurement part 76 and a plurality of second measurement parts 77a, 77b, 77c, and 77d and a holding apparatus 70 includes a first holding part 71 and a moving part 72.

For example, the first holding part 71 holds the wafer 200 through suction or the like. The first holding part 71 holds the first surface 203 of the unexposed wafer 200. More specifically, the first holding part 71 holds a center region 203d including the center of the first surface 203.

The moving part 72 rotates the first holding part 71 about a first axis 04 intersecting the first surface 203 of the wafer 200. When the moving part 72 rotates the first holding part 71, the wafer 200 is rotated about the first axis 04 parallel to the Z axis. The moving part 72 is fixed to the first frame 73.

The first measurement part 76 has a first measurement region 204c. The first measurement region 204c is a region in which the first measurement part 76 measures the wafer 200. The first measurement part 76 can measure the position in the thickness direction (first direction) D3 parallel to the Z axis in the second surface 204 of the wafer 200. The first measurement part 76 can measure the position in the thickness direction D3 parallel to the Z axis of the second surface 204 in the first measurement region 204c.

The center region 203d and the first measurement region 204c are located on the first axis 04. That is, the first axis 04 passes through the center region 203d. The first axis 04 passes through the first measurement region 204c.

The first measurement part 76 is fixed to a second frame 79. The first frame 73 and the second frame 79 are arranged away from each other in the Z-axis direction to face each other.

Furthermore, the first measurement part 76 may have a measurement region different from the first measurement region 204c.

As shown in FIG. 15, the second measurement parts 77a to 77d are arranged toward the outside in the radial direction of the wafer 200 in the order of the second measurement parts 77a, 77b, 77c, and 77d. The second measurement parts 77a to 77d are fixed to the first frame 73 not to contact the wafer 200 along the X axis. Furthermore, the second measurement parts 77a to 77d may not be arranged along the X axis and may be arranged at different positions around the first axis 04.

As shown in FIGS. 15 and 16, each of the second measurement parts 77a to 77d includes a second measurement region 203e. The plurality of second measurement regions 203e are located on the first surface 203. The plurality of second measurement regions 203e are regions in which the second measurement parts 77a to 77d measure the wafer 200. Each of the second measurement parts 77a to 77d can measure the position in the thickness direction D3 (the Z-axis direction) of the first surface 203 in the second measurement region 203e.

The plurality of second measurement regions 203e are regions different from the first measurement region 204c. The distances between the plurality of second measurement regions 203e and the first axis 04 are different.

Hereinafter, a region including two second measurement regions 203e corresponding to the second measurement parts 77c and 77d (a part of the plurality of second measurement regions 203e) in the plurality of second measurement regions 203e is called an outer measurement region 203e1. A region including two second measurement regions 203e corresponding to the second measurement parts 77a and 77b (the remainder of the plurality of second measurement regions 203e) in the plurality of second measurement regions 203e is called an inner measurement region 203e2.

The inner measurement region 203e2 is disposed closer to the first axis 04 on the inside in the radial direction of the wafer 200 than the outer measurement region 203e1.

For example, when the wafer 200 has a diameter of 300 mm, a circular region of 75 mm from the first axis 04 in the plane defined by the X and Y axes may be defined as the inner measurement region 203e2 and the region on the outer ring may be defined as the outer measurement region 203e1. In the example of FIGS. 15 and 16, the distance between two second measurement regions 203e included in the outer measurement region 203e1 is narrower than the distance between two second measurement regions 203e included in the inner measurement region 203e2. That is, the difference between the distance from the first axis 04 to the second measurement part 77c and the distance from the first axis 04 to the second measurement part 77d is smaller than the difference between the distance from the first axis 04 to the second measurement part 77a and the distance from the first axis 04 to the second measurement part 77d.

By rotating the wafer 200 about the first axis 04 using the moving part 72, each of the second measurement parts 77a to 77d can measure the position in the thickness direction D3 at a plurality of rotation positions of the wafer 200.

Furthermore, the second measurement parts 77a to 77d may measure the position in the thickness direction D3 of the second surface 204 of the wafer 200. That is, at least one of the second measurement parts 77a to 77d may be provided in the second frame 79. The number of second measurement parts included in the measurement apparatus 75 may be one to three, or five or more.

Further, the number of second measurement parts included in the outer measurement region 203e1 may be larger than the number of second measurement parts included in the inner measurement region 203e2.

Further, the first measurement part 76 and the second measurement parts 77a to 77d may be capacitance sensors, inductive sensors, or optical sensors including a light receiving unit. Further, the first measurement part 76 and the second measurement parts 77a to 77d may be different types of sensors.

Similarly to the first embodiment, the measurement apparatus 75 measures the shape of the unexposed wafer 200. The control apparatus CONT may determine whether or not the wafer 200 is transported toward the exposure apparatus 35 using the transport robot of the transport system 15 based on the measurement result of the first measurement part 76 and the measurement result of the second measurement parts 77a to 77d.

For example, the measurement result is the warpage amount of the wafer 200. The memory of the control apparatus CONT stores a predetermined warpage amount threshold value.

For example, the control apparatus CONT determines that the wafer 200 is to be transported from the transport system 15 toward the exposure apparatus if the warpage amount according to the measurement result is smaller than the warpage amount threshold value. The control apparatus CONT determines that the wafer 200 should not be transported toward the exposure apparatus 35 by the transport system 15 if the warpage amount according to the measurement result is equal to or larger than the warpage amount threshold value. The wafer 200 that is determined not to be transported may be returned to the interface device 50 or may be moved to the carrier 31 using the transport robot 17 and the loading robot 20.

As described above, in the exposure system 1 of this embodiment, the first surface 203 of the wafer 200 is held by the first holding part 71 of the holding apparatus 70 of the measurement apparatus 75. The first measurement part 76 of the measurement apparatus 75 measures the position in the thickness direction D3 of the first measurement region 204c of the second surface 204. The second measurement parts 77a to 77d of the measurement apparatus 75 measure the position in the thickness direction D3 of the second measurement region 203e of the first surface 203. Then, the control apparatus CONT can determine whether or not the wafer 200 is to be transported toward the exposure apparatus by the transport system 15 based on the measurement result of the first measurement part 76 and the measurement result of the second measurement parts 77a to 77d.

The holding apparatus 70 includes the moving part 72 and rotates the wafer 200 about the first axis 04 by rotating the first holding part 71 using the moving part 72. Therefore, the wafer 200 can be rotated about the first axis 04 by the moving part 72 of the holding apparatus 70.

In general, in the warped wafer, the displacement amount in the thickness direction increases toward the outside in the radial direction. The second measurement parts 77a to 77d are arranged so that the interval between the outer measurement regions 203e1 is narrower than the interval between the inner measurement regions 203e2. Therefore, the displacement of the outer peripheral portion 202 of the wafer 200 which has a large displacement amount can be measured with high accuracy.

The first holding part 71 holds the center region 203d of the first surface 203 and the center region 203d and the first measurement region 204c are located on the first axis 04. Then, the plurality of second measurement regions 203e are located on the first surface 203.

The first holding part 71 holds the center region 203d. In this state, at the same time, it is possible to hold the wafer 200 and measure the wafer using the first measurement region 204c on the first axis 04 by measuring the first measurement region 204c located on the first axis 04 using the first measurement part 76. The second measurement parts 77a to 77d can measure the wafer 200 from the side of the first surface 203 that holds the wafer 200.

The first measurement part 76 can measure the position in the thickness direction D3 of the second surface 204 in the first measurement region 204c and the second measurement parts 77a to 77d can measure the position in the thickness direction D3 of the first surface 203 in the second measurement region 203e. Accordingly, it is possible to measure the position in the thickness direction D3 on both surfaces 203 and 204 in the thickness direction D3 of the wafer 200.

Furthermore, the control apparatus CONT may measure the thickness of the wafer 200 based on the measurement result of the reference wafer 210 by the first measurement part 76 and the measurement result of the wafer 200 by the first measurement part 76. Then, the warpage amount of the wafer 200 may be measured based on the measurement result of the reference wafer 210 by the first measurement part 76 and the second measurement parts 77a to 77d and the measurement result of the wafer 200 by the first measurement part 76 and the second measurement parts 77a to 77d.

In this case, the thickness and the warpage amount of the wafer 200 can be easily measured by using the reference wafer 210. Furthermore, the reference wafer 210 may not be measured as described in the first embodiment.

Furthermore, the holding apparatus 70 may not include the moving part 72.

The first holding part 71 may hold the outer peripheral portion 202 of the wafer 200.

Furthermore, in the embodiments and modified examples described above, the measurement apparatus (16, 75) may be a three-dimensional shape measurement apparatus that measures the warpage shape of the wafer 200 using a camera.

Further, in the embodiments and modified examples described above, the control apparatus CONT may control at least one operation of the transport system (15, 15A) and the exposure apparatus 35 based on the measurement result of the measurement apparatus (16, 75). For example, at least one of the robots 17, 19, 20, and 21, the sliders 38 and 40, and the movable pin 39b may be controlled based on the measurement result.

Hereinafter, each of the robots 17, 19, 20, and 21, the sliders 38 and 40, the movable pin 39b, the loading apparatus 46, and the unloading apparatus 48may be called a transport apparatus.

For example, the speed and/or acceleration of transporting the wafer 200 of at least one of the plurality of transport apparatuses may be controlled based on the measurement result. For example, when the warpage amount of the wafer 200 is larger than the threshold value as the measurement result, the wafer transport speed, the wafer transport acceleration, or both may be made smaller than when transporting the wafer 200 whose warpage amount is smaller than the threshold value.

With such a configuration, for example, it is possible to prevent the wafer 200 from falling from the transport apparatus or from shifting the wafer 200 on the transport apparatus during the transportation of the wafer 200.

In the embodiments and modified examples described above, at least one of the plurality of transport apparatuses may be configured to be able to adjust the inclination of the wafer holding surface of each holding apparatus with respect to a horizontal plane. For example, the wafer holding surface includes at least one of the upper surface of the first wall portion 57A and the upper surface of the third wall portion 57B. In this case, the control apparatus CONT may adjust the inclination of the wafer holding surface of at least one of the plurality of transport apparatuses based on the measurement result by the measurement apparatus (16, 75). Furthermore, the inclination of the upper surface of the first wall portion 57A and the inclination of the upper surface of the third wall portion 57B may be separately controlled based on the measurement result.

With such a configuration, the inclination of the wafer holding surface is adjusted according to the shape of the wafer 200 and the wafer 200 can be held securely.

In the embodiments and modified examples described above, the control apparatus CONT may control the transport path of the wafer 200 within the exposure system 1 based on the measurement result of the measurement apparatus (16, 75). For example, the control apparatus CONT may control the wafer 200 not to be transported toward the exposure apparatus 35 based on the measurement result of the measurement apparatus (16, 75). For example, when the warpage amount of the wafer 200 is equal to or larger than a threshold value as the measurement result, the wafer 200 may be returned to the interface device 50 or may be moved to the carrier 31. With such a configuration, for example, it is possible to prevent the wafer 200 that cannot be properly held on the wafer stage 39 and cannot be exposed from being carried into the exposure apparatus 35.

In the embodiments and modified examples described above, the control apparatus CONT may control the squeeze force applied to the wafer 200 by at least one of the plurality of transport apparatuses based on the measurement result of the measurement apparatus (16, 75). The squeeze force referred to here means the force that holds the wafer 200 by suction or the like. More specifically, the squeeze force refers to the squeeze film force that is generated between the wafer and the wafer holder when the wafer is lowered.

It is generally known that the wafer will be placed without wrinkles if the center of the wafer contacts the stage. Therefore, the ideal way to place the wafer is to place the wafer on the stage in a shape that is slightly convex downward rather than flat.

Since the squeeze film force is a function of speed, the squeeze force can be changed by changing the speed of the wafer 200. It is conceived that the wafer 200 can be placed on the wafer holder in an optimal shape by changing the speed (squeeze film force) depending on the shape of the wafer 200.

When the wafer 200 is sucked and held by the plurality of movable pins 39b of the wafer stage 39 and lowered at a high speed, a stronger upward force acts on the bottom edge of the wafer 200 compared to the case in which the wafer 200 is lowered at a slow speed. Compared to the case in which the shape of the wafer 200 held by the wafer stage 39 is convex downward, when the shape is convex upward, the wafer 200 is adjusted to a downwardly convex shape by lowering the wafer 200 at a high speed. If the speed is slow, the wafer 200 will remain convex upward.

Furthermore, in the measurement station 45, even when the wafer 200 is loaded from the loading apparatus 46 to the wafer stage 47, the wafer 200 can be placed on the wafer holder of the wafer stage 47 in an optimal shape by adjusting the squeeze force.

By controlling the squeeze force based on the measurement result of the measurement apparatus (16, 75), for example, the wafer 200 can be placed in the holder of the wafer stage (39, 47) in an optimal shape and the wafer 200 can be held by the wafer stage (39, 47) in a desired shape (for example, almost flat). Furthermore, controlling the squeeze force based on the measurement result of the measurement apparatus (16, 75) means controlling at least one of the plurality of transport apparatuses based on the measurement result of the measurement apparatus (16, 75).

In the embodiments and modified examples described above, at least one of the plurality of transport apparatuses may include a suction apparatus (for example, Vac1) that sucks and holds the wafer 200. In this case, the control apparatus CONT may control the suction force of the suction apparatus of at least one transport apparatus provided with the suction apparatus based on the measurement result of the measurement apparatus (16, 75).

With such a configuration, for example, the wafer 200 may fall from the transport apparatus, the wafer 200 may be displaced on the transport apparatus, or the shape of the wafer 200 may be adjusted.

In the embodiments and modified examples described above, the transport system (15, 15A) of the exposure system 1 may include a temperature control apparatus. The temperature control apparatus controls the temperature of the wafer 200 transported to the exposure apparatus 35. When the exposure system 1 includes the temperature control apparatus, the control apparatus CONT may control the temperature of the wafer 200 using the temperature control apparatus based on the measurement result of the measurement apparatus (16, 75).

For example, the control apparatus CONT may control the time during which the temperature control apparatus heats the wafer 200 or the time during which the temperature control apparatus cools the wafer 200 based on the measurement result of the measurement apparatus (16, 75).

Further, when the temperature control apparatus includes a suction apparatus for sucking and holding the wafer 200, the control apparatus CONT may control the suction force by the suction apparatus of the temperature control apparatus based on the measurement result of the measurement apparatus (16, 75).

Further, when the temperature control apparatus includes a rotating apparatus for rotating the held wafer 200, the control apparatus CONT may control the rotational speed of the wafer 200 by the rotating apparatus of the temperature control apparatus, the rotational acceleration, or both based on the measurement result of the measurement apparatus (16, 75).

With such a configuration, the wafer 200 is controlled to an appropriate temperature. Further, the wafer 200 controlled to an appropriate temperature can be transported to the exposure apparatus 35.

In each of the embodiments and modified examples described above, the transport system (15, 15A) of the exposure system 1 may include a rotating apparatus that rotates the wafer 200.

When the transport system (15, 15A) includes a rotating apparatus, the control apparatus CONT may control the rotational speed of the wafer 200 by the rotating apparatus, the rotational acceleration, or both based on the measurement result of the measurement apparatus (16, 75).

With such a configuration, it is possible to prevent the wafer 200 from falling from the rotating apparatus or from shifting the position of the wafer 200 on the rotating apparatus.

Furthermore, in each of the embodiments and modified examples described above, the measurement apparatus (16, 75) includes the moving part (27, 72), but the rotation of the wafer 200 using the moving part (27, 72) may be controlled based on the measurement result of the measurement apparatus (16, 75). For example, the shape (warpage amount or the like) of the wafer 200 may be measured using the first measurement part (28, 76) and the second measurement part (29a to 29d, 77a to 77d) before rotating the wafer 200 by the moving part (27, 72) and the rotation of the wafer 200 using the moving part (27, 72) may be controlled based on the measurement result.

In each of the embodiments and modified examples described above, in the exposure apparatus 35, focus adjustment is performed to adjust the positional relationship between the focal position of the energy beam irradiated onto the wafer 200 and the surface (204) of the wafer 200.

The control apparatus CONT may control the focus adjustment of the exposure apparatus 35 based on the measurement result of the measurement apparatus (16, 75). For example, the focus adjustment of the exposure apparatus 35 may be controlled in a feedforward manner based on the measurement result of the measurement apparatus (16, 75).

With such a configuration, in the exposure apparatus 35, the energy beam can be irradiated onto the wafer 200 while the focal position of the energy beam and the surface of the wafer 200 are properly aligned.

In each of the embodiments and modified examples described above, the control apparatus CONT may transmit information on the measurement result of the measurement apparatus (16, 75) to a host computer that manages the exposure system 1.

With such a configuration, for example, information on the measurement result of the measurement apparatus (16, 75) can be shared with the coater/developer 10, other exposure systems, semiconductor manufacturing equipment different from the exposure system, and the like via the host computer.

In each of the embodiments and modified examples described above, the control apparatus CONT may store information on the measurement result of the measurement apparatus (16, 75) as log data of the exposure system 1.

With such a configuration, for example, the operator of the exposure system 1 can recognize processes executed by the exposure system 1 and processes not executed by the exposure system by accessing the log data.

(Third embodiment)

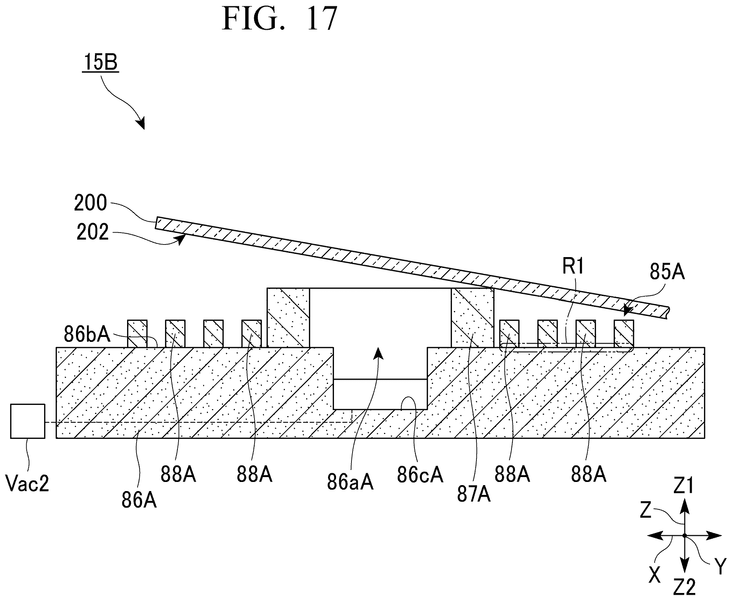

Next, a third embodiment of the present invention will be described with reference to FIG. 17, but the same parts as in the above-described embodiments are indicated by the same reference numerals and the description thereof will be omitted.

As shown in FIG. 17, the exposure system 1 of this embodiment is different from the transport system 15 in that a transport system 15B is provided instead of the transport system 15 and the transport system 15B includes a third holding apparatus 85A and a fourth holding apparatus 85B.

In this embodiment, the transport robot 17, the transport robot 19, the loading robot 20, and the unloading robot 21 include the third holding apparatus 85A and the fourth holding apparatus 85B. Furthermore, a part (one or more) of the transport robot 17, the transport robot 19, the loading robot 20, and the unloading robot 21 may include holding apparatuses (for example, the first holding apparatus 55A and the second holding apparatus 55B) other than the third holding apparatus 85A and the fourth holding apparatus 85B.

The third holding apparatus 85A includes a third opening 86aA, a fifth wall portion 87A, and a plurality of first protrusions 88A.

For example, the third opening 86aA is formed in the first base 86A. The first base 86A has a flat plate shape and is disposed along the horizontal plane. The third opening 86aA is formed in a fifth surface 86bA which is the upper surface of the first base 86A. In the first base 86A, a discharge hole 86cA is formed in the bottom portion of the third opening 86aA. One end of the discharge hole 86cA is the third opening 86aA. The other end of the discharge hole 86cA is connected to a suction apparatus Vac2.

When the suction apparatus Vac2 is operated, a gas inside the third opening 86aA can be sucked through the discharge hole 86cA.

The fifth wall portion 87A is formed in an annular shape. More specifically, in the plane parallel to the plane defined by the X and Y axes, the fifth wall portion 87A is disposed so that a region surrounded by the fifth wall portion 87A has an elongated oval shape. The fifth wall portion 87A is provided on the fifth surface 86bA to surround the third opening 86aA. The fifth wall portion 87A protrudes toward the first side Z1 in the first direction Z intersecting the fifth surface 86bA more than the first base 86A. That is, the fifth wall portion protrudes in the Z1 direction. Here, one of the directions parallel to the fifth surface 86bA is defined as a second direction X (X-axis direction). At least a part of the fifth wall portion 87A contacts the wafer 200.

The third opening 86aA is formed in the middle portion of the long axis direction (Y-axis direction) in a region surrounded by the fifth wall portion 87A.

In this embodiment, the plurality of first protrusions 88A are provided in a protrusion region R1 around the fifth wall portion 87A. The plurality of first protrusions 88A are provided on the outside of the fifth wall portion 87A with respect to the third opening 86aA. The plurality of first protrusions 88A are arranged at intervals. The plurality of first protrusions 88A are arranged at intervals along the fifth wall portion 87A. The plurality of first protrusions 88A are spaced outward from the fifth wall portion 87A and are arranged to surround the fifth wall portion 87A.

In the plane parallel to the plane defined by the X and Y axes, the wall of the fifth wall portion 87A is thicker than each of the plurality of first protrusions 88A, but the length of the protrusion region R1 is longer than the thickness of the fifth wall portion 87A.

For example, the length of the fifth wall portion 87A in the second direction X is longer than the length of each first protrusion 88A in the second direction X. For example, the length of the protrusion region R1 in which the plurality of first protrusions 88A are arranged in the second direction X is longer than the length of the fifth wall portion 87A in the second direction X.

Furthermore, the number of the first protrusions 88A provided in the third holding apparatus 85 may be one.

The height of the tip on the first side Z1 of the first protrusion 88A (the height in the Z1 direction) is lower than the height of the tip on the first side Z1 of the fifth wall portion 87A (the height in the Z1 direction). That is, the tip on the first side Z1 of the first protrusion 88A is located closer to the second side Z2 in the first direction Z than the tip on the first side Z1 of the fifth wall portion 87A.

As described above, in the third holding apparatus 85A of this embodiment, the height of the tip of the first protrusion 88A in the first direction Z is lower than the height of the tip of the fifth wall portion 87A in the first direction Z. Therefore, since the distance to the wafer 200 on the outside of the fifth wall portion 87A is relatively narrow compared to the case in which the first protrusion 88A is not provided in the third holding apparatus 85A, a gas becomes difficult to flow into the fifth wall portion 87A through the outside of the fifth wall portion 87A. Therefore, for example, when a gas is sucked through the third opening 86aA, the outer peripheral portion 202 of the wafer 200 can be reliably held by the fifth wall portion 87A by suction.

The plurality of first protrusions 88A are arranged at intervals in the second direction X. Accordingly, it is possible to secure a wide range in the second direction X in which the distance to the wafer 200 is relatively narrow and a gas becomes difficult to flow.

The length of the protrusion region R1 in the second direction X is longer than the length of the fifth wall portion 87A in the second direction X. Accordingly, it is possible to secure a wide range in the second direction X in which the distance to the wafer 200 is relatively narrow and a gas becomes difficult to flow.

The plurality of first protrusions 88A are arranged at intervals along the fifth wall portion 87A. Therefore, it is possible to secure a wide range along the fifth wall portion 87A in which the distance to the wafer 200 is relatively narrow and a gas becomes difficult to flow.

The fifth wall portion 87A has an elongated oval shape and the third opening 86aA is formed in the middle portion of the fifth wall portion 87A in the long axis direction. Therefore, the pressure loss of the gas flowing inside the fifth wall portion 87A can be reduced compared to the case in which the third opening 86aA is formed at the end portion of the fifth wall portion 87A in the long axis direction.

At least a part of the fifth wall portion 87A contacts the wafer 200. Therefore, the outer peripheral portion 202 of the wafer 200 can be held by the fifth wall portion 87A through suction.

Further, the third holding apparatus 85A has been described so far, but the fourth holding apparatus 85B has a similar configuration.

The height of the tip in the first direction Z of the second protrusion 88B of the fourth holding apparatus 85B corresponding to the first protrusion 88A of the third holding apparatus 85A is lower than the height of the tip in the first direction Z of the sixth wall portion 87B of the fourth holding apparatus 85B corresponding to the fifth wall portion 87A of the third holding apparatus 85A. Therefore, since the distance to the wafer 200 on the outside of the sixth wall portion 87B is relatively narrow compared to the case in which the plurality of second protrusions 88B are not provided in the fourth holding apparatus 85B, a gas becomes difficult to flow into the sixth wall portion 87B through the outside of the sixth wall portion 87B when a discharge operation is performed through a fourth opening 86aB of the fourth holding apparatus 85B corresponding to the third opening 86aA of the third holding apparatus 85A. Therefore, also in the fourth holding apparatus 85B, the outer peripheral portion 202 of the wafer 200 can be reliably held by the sixth wall portion 87B through suction.

Furthermore, also in the third holding apparatus 85A, the outer peripheral portion 202 of the wafer 200 can be reliably held by the fifth wall portion 87A through suction.

The third holding apparatus 85A and the fourth holding apparatus 85B have a symmetrical shape with respect to the axis parallel to the fifth surface 86bA or the sixth surface 86bB. Accordingly, the third holding apparatus 85A and the fourth holding apparatus 85B can be arranged to face each other with the wafer 200 interposed therebetween.

The third holding apparatus 85A and the fourth holding apparatus 85B are arranged at symmetrical positions with respect to the axis parallel to the fifth surface 86bA or the sixth surface 86bB. Therefore, the third holding apparatus 85A and the fourth holding apparatus 85B can be arranged to face each other with the wafer 200 interposed therebetween.

Furthermore, in this embodiment, the plurality of protrusions (88A, 88B) are continuously formed to surround the entire circumference of the wall portions (87A, 87B). However, at least one of the plurality of protrusions (88A, 88B) may be intermittently formed to surround the wall portions (87A, 87B) and at least one of the plurality of protrusions (88A, 88B) may be provided only in a part (for example, only one side of the wall portions (87A, 87B) in the X-axis direction) around the wall portions (87A, 87B).

Further, the difference in height between the wall portions (87A, 87B) and the protrusions (88A, 88B) is from several hundred $\mu$m (micrometers) to several thousand $\mu$m, and may be, for example, from 300 $\mu$m to 1000 $\mu$m.

Furthermore, the heights of the plurality of first protrusions 88A may not be the same. For example, the plurality of first protrusions 88A may gradually become lower as they move away from the fifth wall portion 87A.

Further, the length of the wall portions (87A, 87B) in the second direction X (X-axis direction) may be equal to or shorter than the length of each protrusion (88A, 88B) in the second direction X.

Further, the length in the second direction X of the protrusion region in which the plurality of protrusions (88A, 88B) are formed may be equal to or shorter than the length of the wall portions (87A, 87B) in the second direction X.

The openings (86aA, 86aB) may be formed at the end portions of the wall portions (87A, 87B) in the long axis direction (Y-axis direction). Further, the shape of the region surrounded by the wall portions (87A, 87B) may be circular, polygonal, or the like.

Further, the third holding apparatus 85A and the fourth holding apparatus 85B may have an asymmetrical shape with respect to the parallel axis. The third holding apparatus 85A and the fourth holding apparatus 85B may be arranged at asymmetrical position with respect to the axis.

(Fourth embodiment)

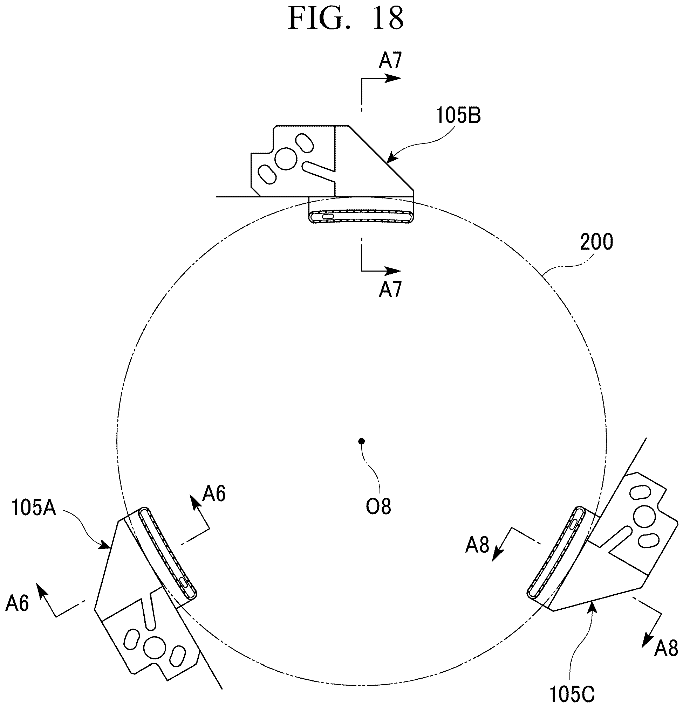

Next, a fourth embodiment of the present invention will be described with reference to FIGS. 18 to 22, but the same parts as in the above-described embodiments are indicated by the same reference numerals and the description thereof will be omitted.

As shown in FIG. 18, the exposure system 1 of this embodiment includes a transport system 15C instead of the transport system 15 and the transport system 15C includes a fifth holding apparatus 105A, a sixth holding apparatus 105B, and a seventh holding apparatus 105C. In this embodiment, the transport robot 17, the transport robot 19, the loading robot 20, and the unloading robot 21 include the fifth holding apparatus 105A, the sixth holding apparatus 105B, and the seventh holding apparatus 105C.

Furthermore, a part (one or more) of the transport robot 17, the transport robot 19, the loading robot 20, and the unloading robot 21 may include holding apparatuses (for example, the holding apparatuses 55A and 55B or the holding apparatuses 85A and 85B) other than the fifth holding apparatus 105A, the sixth holding apparatus 105B, and the seventh holding apparatus 105C.

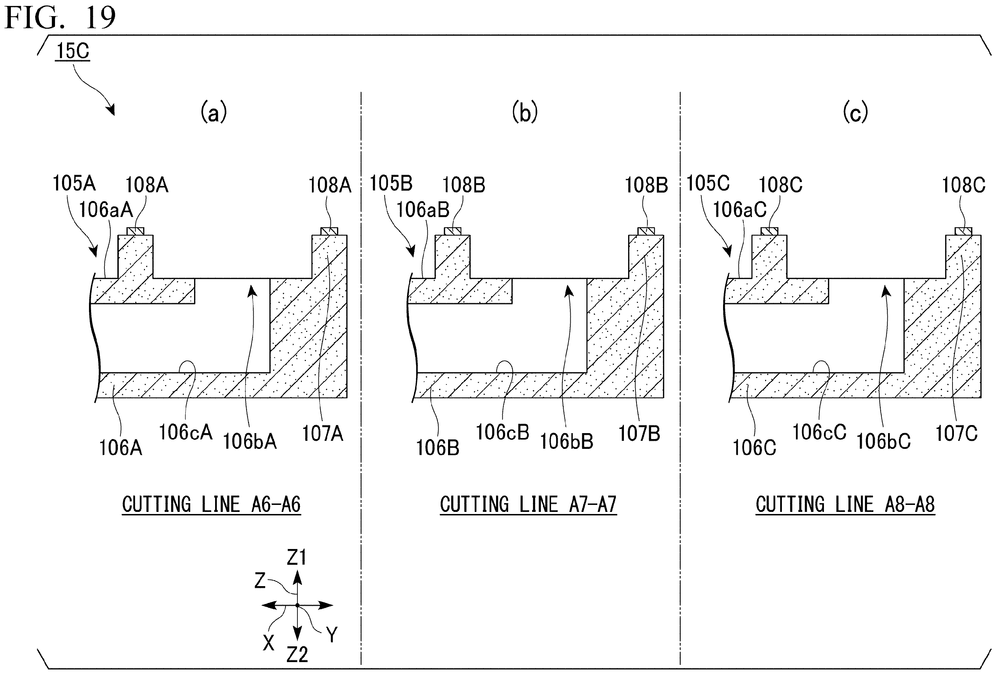

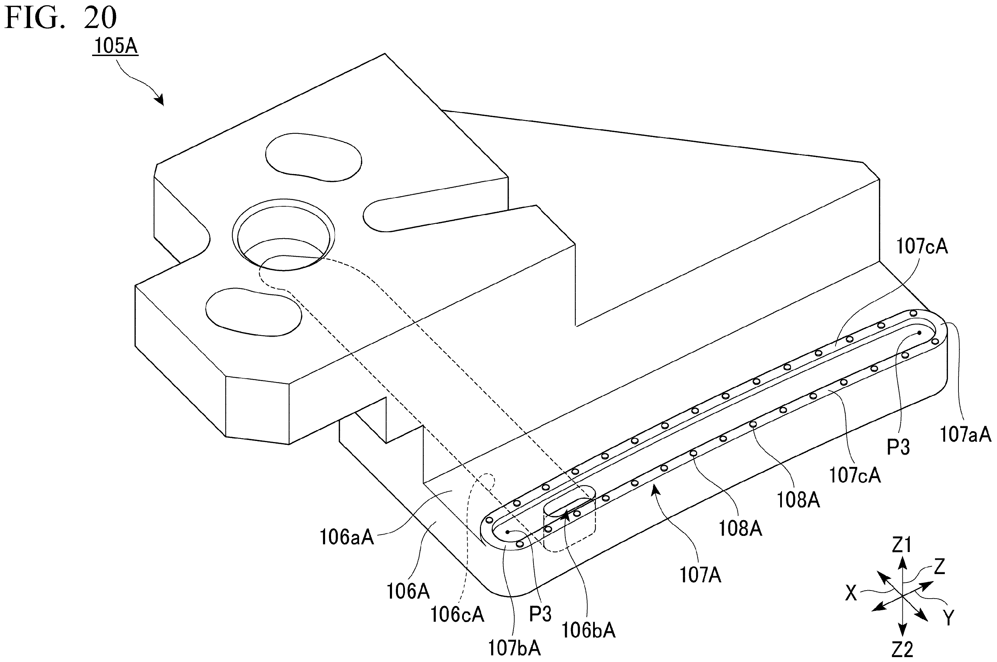

As shown in FIGS. 19 and 20, the fifth holding apparatus 105A includes a base 106A, a seventh wall portion 107A, and a plurality of third protrusions 108A.

For example, the base 106A has a flat plate shape, is disposed along the horizontal plane, and includes a seventh surface 106aA parallel to the plane defined by the X and Y axes. A fifth opening 106bA is formed in the seventh surface 106aA which is the upper surface of the base 106A.

A discharge hole 106cA is formed in the base 106A. One end of the discharge hole 106cA is the fifth opening 106bA. The discharge hole 106cA extends along the seventh surface 106aA. The other end of the discharge hole 106cA is connected to a suction apparatus (not shown).

As shown in FIG. 20, the seventh wall portion 107A is formed in an annular shape. More specifically, the region surrounded by the seventh wall portion 107A has an elongated oval shape that is long in the Y-axis direction. The seventh wall portion 107A includes a first arcuate wall 107aA, a second arcuate wall 107bA, and a pair of connecting walls 107cA. The first arcuate wall 107aA and the second arcuate wall 107bA are each formed in an arcuate shape centered on the reference point P3 when viewed from the first direction Z. The first arcuate wall 107aA and the second arcuate wall 107bA are spaced away from each other in the circumferential direction of the wafer 200.

The pair of connecting walls 107cA are respectively arranged along the outer peripheral portion 202 of the wafer 200. The pair of connecting walls 107cA connect the end portions of the first arcuate wall 107aA and the second arcuate wall 107bA to each other.

The seventh wall portion 107A is provided in the seventh surface 106aA to surround the fifth opening 106bA. The seventh wall portion 107A protrudes from the base 106A toward the first side Z1 (hereinafter, also simply referred to as the first side Z1) in the first direction Z (Z-axis direction) intersecting the seventh surface 106aA. Here, one of the directions parallel to the seventh surface 106aA is defined as a second direction X (X-axis direction).

The diameter of the fifth opening 106bA in the Y-axis direction is larger than the diameter of the fifth opening 106bA in the X-axis direction.

As shown in FIGS. 19 and 20, the plurality of third protrusions 108A are provided on the seventh wall portion 107A (the end surface on the first side Z1 in the seventh wall portion 107A). The height of the tip on the first side Z1 of each third protrusion 108A is higher than the height of the tip on the first side Z1 of the seventh wall portion 107A (the upper surface of the seventh wall portion 107A). That is, the tip on the first side Z1 of each third protrusion 108A is located closer to the first side Z1 than the tip on the first side Z1 of the seventh wall portion 107A in the Z-axis direction.

The upper surface of each of the first arcuate wall 107aA, the second arcuate wall 107bA, and the pair of connecting wall 107cA constituting the seventh wall portion 107A has a width and each third protrusion 108A is provided at the center portion of the seventh wall portion 107A. The width of the third protrusion 108A is narrower than the width of the seventh wall portion 107A. That is, the seventh wall portion 107A protrudes toward both sides in the second direction X in relation to the third protrusion 108A. The length of the third protrusion 108A in the first direction Z is shorter than the length of the seventh wall portion 107A in the first direction Z.

The plurality of third protrusions 108A are arranged at intervals along the seventh wall portion 107A. The plurality of third protrusions 108A may be provided only in the first arcuate wall 107aA and the second arcuate wall 107bA of the seventh wall portion 107A. The plurality of third protrusions 108A may be provided only in the pair of connecting walls 107cA. The plurality of third protrusions 108A may be provided only in one of the pair of connecting wall 107cA (for example, only the connecting wall 107cA close to an axis O8).

At least a part of the plurality of third protrusions 108A contacts the wafer 200.

Furthermore, the number of third protrusions 108A provided in the fifth holding apparatus 105A may be one.

When the suction apparatus is operated, the fifth holding apparatus 105A can suck a gas located between the base 106A and the wafer 200 through the fifth opening 106bA of the discharge hole 106cA.

As shown in FIGS. 18 and 19, the sixth holding apparatus 105B and the seventh holding apparatus 105C are configured similarly to the fifth holding apparatus 105A.

As shown in FIG. 19, the sixth holding apparatus 105B includes a base 106B, an eighth wall portion 107B, and a plurality of fourth protrusions 108B.

For example, the base 106B has a flat plate shape and is disposed along the horizontal plane. A sixth opening 106bB is formed in an eighth surface 106aB which is the upper surface of the third base 106B.

A discharge hole 106cB is formed in the base 106B. One end of the discharge hole 106cB is the sixth opening 106bB. The discharge hole 106cB extends along the eighth surface 106aB. The other end of the discharge hole 106cB is connected to a suction apparatus (not shown).

The eighth wall portion 107B is formed in an annular shape. The eighth wall portion 107B is provided in the eighth surface 106aB to surround the sixth opening 106bB. The eighth wall portion 107B protrudes toward the first side Z1.

The plurality of fourth protrusions 108Bare provided on the eighth wall portion 107B (the end surface on the first side Z1 of the eighth wall portion 107B) along the eighth wall portion 107B.

The height of the tip on the first side Z1 of the plurality of fourth protrusions 108B is higher than the height of the tip on the first side Z1 of the eighth wall portion 107B. That is, the tip on the first side Z1 of the fourth protrusion 108B is located closer to the first side Z1 than the tip on the first side Z1 of the eighth wall portion 107B.

When the suction apparatus is operated, the sixth holding apparatus 105B can suck a gas located between the base 106B and the wafer 200 through the sixth opening 106bB of the discharge hole 106cB.

The seventh holding apparatus 105C includes a base 106C, a ninth wall portion 107C, and a plurality of fifth protrusions 108C.

A seventh opening 106bC is formed in a ninth surface 106aC which is the upper surface of the base 106C.

A discharge hole 106cC is formed in the base 106C. One end of the discharge hole 106cC is the seventh opening 106bC. The discharge hole 106cC extends along the ninth surface 106aC. The other end of the discharge hole 1106cC is connected to a suction apparatus (not shown).

The ninth wall portion 107C is formed in an annular shape. The ninth wall portion 107C is provided in a ninth surface 106a7C to surround the seventh opening 106bC. The ninth wall portion 107C protrudes toward the first side Z1.

The plurality of fifth protrusions 108C are provided on the ninth wall portion 107C along the ninth wall portion 107C.

The height of the tip on the first side Z1 of the plurality of fifth protrusions 108C is higher than the height of the tip on the first side Z1 of the ninth wall portion 107C.

When the suction apparatus is operated, a gas located between the base 106C and the wafer 200 can be sucked through the seventh opening 106bC of the discharge hole 106cC.

Here, as shown in FIG. 18, a third axis 08 is defined that intersects each of the seventh surface 106aA of the fifth holding apparatus 105A, the eighth surface 106aB of the sixth holding apparatus 105B, and the ninth surface 106aC of the seventh holding apparatus 105C.

The fifth holding apparatus 105A, the sixth holding apparatus 105B, and the seventh holding apparatus 105Chave shapes that are symmetrical (multiple rotational symmetry) with respect to the third axis 08.

In other words, the fifth holding apparatus 105A, the sixth holding apparatus 105B, and the seventh holding apparatus 105C are arranged symmetrically with respect to the third axis O8.

The fifth holding apparatus 105A, the sixth holding apparatus 105B, and the seventh holding apparatus 105Care arranged at equal angles around the third axis O8, but may not be arranged at equal intervals.

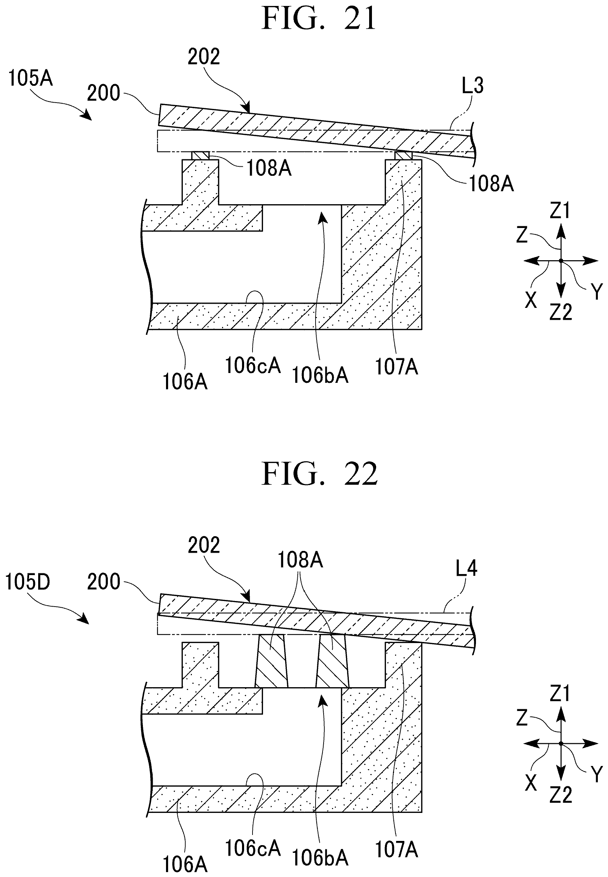

For example, when the suction apparatus of the fifth holding apparatus 105A is operated, as shown in FIG. 21, a gas between the base 106A and the wafer 200 is sucked. As indicated by the two-dot chain line L3 in FIG. 21, the warped wafer 200 comes into contact with the end surface on the first side Z1 of the plurality of third protrusions 108A. At this time, the wafer 200 does not contact the end surface on the first side Z1 of the seventh wall portion 107A.

In this way, the wafer 200 is held by the fifth holding apparatus 105A. Similarly, the wafer 200 is held by each of the holding apparatuses 105B and 105C.

Here, an example of a holding apparatus 105D will be described with reference to FIG. 22.

In the holding apparatus 105D, the plurality of third protrusions 108A are arranged inside the wall portion 107A in the holding apparatus 105A.

When the suction apparatus of the holding apparatus 105D are operated, as indicated by the two-dot chain line L4 in FIG. 22, the warped wafer 200 comes into contact with the end surfaces on the first side Z1 of the plurality of protrusions 108A. At this time, there is a risk that the wafer 200 may come into contact with the end surface on the first side Z1 of the wall portion 107A.

Furthermore, in the fifth holding apparatus 105A of this embodiment shown in FIG. 21, since the protrusion is not formed inside the wall portion (107A), the flow of the gas toward the opening (106bA) is not obstructed in the inner space of the wall portion (107A), the gas in the inner space of the wall portion (107A) can be smoothly discharged compared to the holding apparatus 105D, and the wafer 200 can be held more reliably.

As described above, in the fifth holding apparatus 105A of this embodiment, the height of the tip on the first side Z1 of the third protrusion 108A is higher than the height of the tip on the first side Z1 of the seventh wall portion 107A. Therefore, for example, when a gas is sucked through the fifth opening 106bA to hold the outer peripheral portion 202 of the wafer 200, the wafer 200 can be prevented from coming into contact with the end surface on the first side Z1 of the seventh wall portion 107A.

The length of the third protrusion 108A in the first direction Z is shorter than the length of the seventh wall portion 107A in the first direction Z. For example, when the width of the third protrusion 108A is narrower than the width of the seventh wall portion 107A, the structure of the third protrusion 108A can be stabilized so that the third protrusion 108A does not break.

The plurality of third protrusions 108A are arranged at intervals in the second direction X. Therefore, the plurality of third protrusions 108A can support the wafer 200 in a relatively wide range of the second direction X.

The plurality of third protrusions 108A are arranged at intervals along the seventh wall portion 107A. Accordingly, the plurality of third protrusions 108A can support the wafer 200 in a relatively wide range along the seventh wall portion 107A.

There is a case in which the plurality of third protrusions 108A are provided only in the first arcuate wall 107aA and the second arcuate wall 107bA of the seventh wall portion 107A. Therefore, the plurality of third protrusions 108A can be provided only in the portion of the seventh wall portion 107A that the wafer 200 easily contacts.

There is a case in which the diameter of the fifth opening 106bA in the long axis direction of the seventh wall portion 107A is larger than the diameter in the short axis direction. In this case, the fifth opening 106bA has a shape along the seventh wall portion 107A having an elongated oval shape and the fifth opening 106bA can be efficiently disposed within the seventh wall portion 107A.

At least a part of the plurality of third protrusions 108A contacts the wafer 200. Therefore, the outer peripheral portion 202 of the wafer 200 can be supported by the third protrusions 108A.

Further, in the transport system 15C of this embodiment, the wafer 200 can be prevented from contacting the end surfaces of the wall portions 107A, 107B, and 107C (for example, the end surface on the first side X1 of the wall portion 107A).

The fifth holding apparatus 105A, the sixth holding apparatus 105B, and the seventh holding apparatus 105Chave a symmetrical shape with respect to the third axis 08. Therefore, the outer peripheral portion 202 of the wafer 200 can be equally supported by the holding apparatuses 105A, 105B, and 105C.

The fifth holding apparatus 105A, the sixth holding apparatus 105B, and the seventh holding apparatus 105Care arranged symmetrically with respect to the third axis 08. Therefore, the outer peripheral portion 202 of the wafer 200 can be equally supported by the holding apparatuses 105A, 105B, and 105C.

Furthermore, in this embodiment, in the holding apparatus (105A, 105B, 105C), the length of the protrusion (108A, 108B, 108C) in the first direction Z may be equal to or longer than the length of the wall portion (107A, 107B, 107C) in the first direction Z.

The plurality of protrusions (108A, 108B, 108C) may be provided only in the pair of connecting walls of the wall portions (107A, 107B, 107C).

The opening (106bA, 106bB, 106bC) may be formed at the end of the wall portion (107A, 107B, 107C) in the long axis direction.

The diameter of the opening (106bA, 106bB, 106bC) in the long axis direction of the wall portion (107A, 107B, 107C) may be equal to or smaller than the diameter in the short axis direction.

Further, in this embodiment, at least one of the transport robot 17, the transport robot 19, the loading robot 20, and the unloading robot 21 includes the fifth holding apparatus 105A, the sixth holding apparatus 105B, and the seventh holding apparatus 105C. At least one of the transport robot 17, the transport robot 19, the loading robot 20, and the unloading robot 21 may include only two holding apparatuses (for example, the fifth holding apparatus 105A and the seventh holding apparatus 105C).

Furthermore, in the embodiments and modified examples described above, the measurement apparatus (16, 75) may not be provided. For example, when the shape of the wafer 200 is measured in the coater/developer 10, information on the measurement result may be received by the control apparatus CONT and used to control the operation of each apparatus of the exposure system 1 as described above. Further, even if there is no information on the shape of the wafer 200, even a deformed (warped) wafer 200 shown in FIGS. 1 to 4, for example, can be held securely by using the above-described holding apparatus.

Further, the holding apparatuses of the embodiments and modified examples described above may be provided inside the coater/developer 10 and used to hold or transport the wafer 200.

Further, in the embodiments and modified examples described above, the exposure apparatus 35 may use KrF excimer laser beam (wavelength 248 nm), ArF excimer laser beam (wavelength 193 nm), or the like as the energy beam, or may use an LED light source as the light source that emits the energy beam.

Further, in the embodiments and modified examples described above, the exposure apparatus 35 may be an immersion exposure apparatus that irradiates the wafer 200 with an energy beam via immersion water between the projection optical system and the wafer 200.

Further, in the embodiments and modified examples described above, the exposure apparatus 35may be a twin stage type exposure apparatus including a plurality of wafer stages.

Although the first to fourth embodiments of the present invention have been described above in detail with reference to the drawings, the specific configuration is not limited to this embodiment, and includes changes, combinations, deletions, and the like of the configuration without departing from the gist of the present invention. Furthermore, it is understood that the configurations shown in each embodiment can be used in appropriate combinations.

For example, the holding apparatuses of the third and fourth embodiments may be used in place of the holding apparatus of the first embodiment.

For example, a device manufacturing method using the exposure system 1 may be performed. This device manufacturing method includes an exposure step. The exposure step includes exposing the wafer 200 whose surface is coated with resist using the exposure system 1 and developing the exposed wafer 200 using the coater/developer 10.

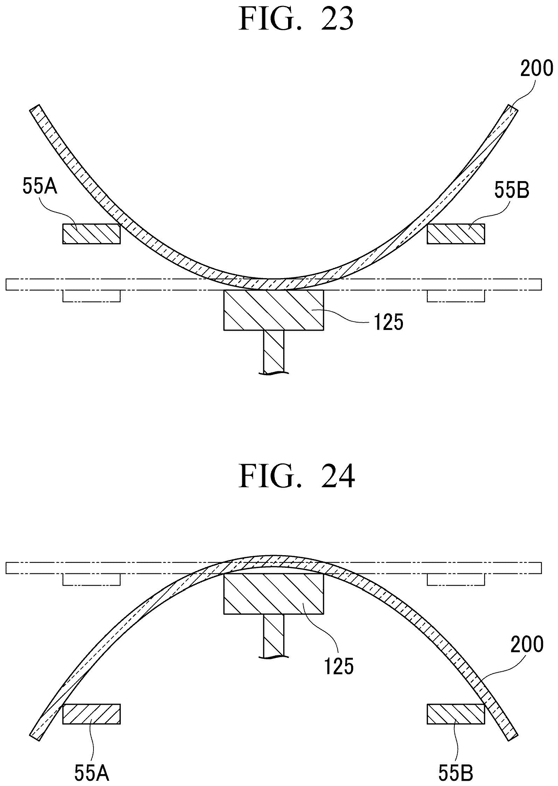

As shown in FIG. 23, when the wafer 200 is warped in a downwardly convex shape, the holding apparatuses 55A and 55B contact the wafer 200 at a position higher than a turntable 125. Furthermore, in FIG. 23, the flat wafer 200 on the turntable 125 is indicated by a two-dot chain line.

On the other hand, as shown in FIG. 24, when the wafer 200 is warped in a upwardly convex shape, the holding apparatuses 55A and 55B contact the wafer 200 at a position lower than the turntable 125.

When the warpage amount of the wafer 200 is known in advance, the accuracy of delivering the wafer 200 can be improved by reducing the moving speed of the holding apparatuses 55A and 55B near the height where the holding apparatuses 55A and 55B contact the wafer 200.

Furthermore, this specification also discloses the inventions described below.

(Additional Claim 1)

A measurement apparatus including:

a holding apparatus which holds a first position of a first surface in a thickness direction of a wafer;
a first measurement part which is able to measure the position in the thickness direction at a second position of the wafer held by the holding apparatus; and
a second measurement part which is able to measure the position in the thickness direction at a third position on the outer peripheral side of the second position in a radial direction of the wafer in the first surface of the wafer or a second surface on the side opposite to the first surface.

(Additional Claim 2)

The measurement apparatus according to additional claim 1, further including:
a moving part which rotates the wafer about a first axis intersecting the first surface of the wafer.

(Additional Claim 3)

The measurement apparatus according to additional claim 2,
wherein the second measurement part is able to measure the position in the thickness direction at a plurality of positions of the wafer rotated about the first axis by the moving part.

(Additional Claim 4)

The measurement apparatus according to additional claim 2 or 3,

wherein a plurality of the second measurement parts are provided,
wherein the distances between the plurality of second measurement parts and the first axis are different from each other, and
wherein the plurality of second measurement parts are arranged so that an interval between the second measurement parts on the outside in the radial direction of the wafer becomes narrower than an interval between the second measurement parts on the inside in the radial direction.

(Additional Claim 5)

The measurement apparatus according to any one of additional claims 1 to 4,

wherein the first position and the second position are located on the first axis, and
wherein the second position is located on the second surface.

(Additional Claim 6)

The measurement apparatus according to any one of additional claims 1 to 5, further including:

a control unit,
wherein the control unit measures the thickness of the wafer based on a measurement result obtained by the first measurement part for a reference wafer whose thickness and warpage amount are known in advance and a measurement result obtained by the first measurement part for the wafer and measures a warpage amount of the wafer based on a measurement result obtained by the first measurement part and the second measurement part for the reference wafer and a measurement result obtained by the first measurement part and the second measurement part for the wafer.

(Additional Claim 7)

The measurement apparatus according to any one of additional claims 1 to 6,
wherein the first measurement part includes a capacitance sensor.

(Additional Claim 8)

The measurement apparatus according to any one of additional claims 1 to 7,
wherein the second measurement part includes a capacitance sensor.

(Additional Claim 9)

The measurement apparatus according to any one of additional claims 1 to 8,

wherein the first measurement part is able to measure the second position of the second surface, and wherein the second measurement part is able to measure the third position of the first surface.

(Additional Claim 10)

An exposure system including:

the measurement apparatus according to any one of additional claims 1 to 9; and an exposure apparatus that exposes a wafer with an energy beam.

(Additional Claim 11)

An exposure method including:
exposing the wafer measured by the measurement apparatus according to any one of additional claims 1 to 9 to an energy beam.

[Industrial Applicability]

According to the present invention, even if the wafer 200 is warped as shown in FIGS. 1 to 4, the wafer 200 can be held securely. Therefore, the industrial applicability is great.

[Reference Signs List]

1 Exposure system
10 Coater/developer
11 Coating apparatus
12 Developing apparatus
15 (15A, 15B, 15C) Transport system
16 Measurement apparatus
35 Exposure apparatus
45 Measurement station
75 Measurement apparatus
55A First holding apparatus
55B Second holding apparatus
85A Third holding apparatus
86A Fourth holding apparatus
105A Fifth holding apparatus
105B Sixth holding apparatus
105C Seventh holding apparatus
CONT Control apparatus

**Claims**

1. An exposure system capable of exposing a wafer transported from a coating apparatus capable of coating a photosensitive material onto the wafer, comprising:

a holding apparatus which includes a first holding part holding a first surface of the wafer transported from the coating apparatus; a measurement apparatus which includes a first measurement part having at least a first measurement region and capable of measuring a position in a first direction of a second surface on the side opposite to the first surface of the wafer held by the first holding part and a second measurement part having at least one second measurement region different from the first measurement region and capable of measuring a position in the first direction of the first surface or the second surface of the wafer; an exposure apparatus which exposes the wafer with an energy beam; a transport apparatus which transports the wafer from the measurement apparatus to the exposure apparatus; and a control apparatus, wherein the control apparatus determines whether or not the wafer is to be transported toward the exposure apparatus by the transport apparatus based on a measurement result of the first measurement part and a measurement result of the second measurement part.

2. The exposure system according to claim 1,

wherein the holding apparatus includes a moving part which rotates the first holding part about a first axis intersecting the first surface of the wafer, and wherein the first holding part is rotated by the moving part to rotate the wafer about the first axis.

3. The exposure system according to claim 2, wherein the position in the first direction in a plurality of rotation positions of the wafer is measurable by rotating the wafer about the first axis using the moving part.

4. The exposure system according to claim 2 or 3,

wherein the second measurement part has a plurality of the second measurement regions, wherein the distances between the plurality of second measurement regions and the first axis are different from each other, wherein the plurality of second measurement regions include a plurality of outer measurement regions and a plurality of inner measurement regions arranged inward in a radial direction of the wafer than the plurality of outer measurement regions, and

wherein the second measurement part is disposed so that an interval of the plurality of outer measurement regions becomes narrower than an interval of the plurality of inner measurement regions.

5. The exposure system according to any one of claims 1 to 4,

wherein the first holding part holds a center region including a center of the first surface,
wherein the center region and the first measurement region are located on a first axis intersecting the first surface of the wafer, and
wherein the second measurement region is located on the first surface.

6. The exposure system according to any one of claims 1 to 5,
wherein the control apparatus measures a thickness of the wafer based on a measurement result obtained by the first measurement part for a reference wafer whose thickness and warpage amount are known in advance and a measurement result obtained by the first measurement part for the wafer and measures a warpage amount of the wafer based on a measurement result obtained by the first measurement part and the second measurement part for the reference wafer and a measurement result obtained by the first measurement part and the second measurement part for the wafer.

7. The exposure system according to any one of claims 1 to 6,

wherein the first measurement part is able to measure a position in the first direction of the second surface in the first measurement region, and
wherein the second measurement part is able to measure a position in the first direction of the first surface in the second measurement region.

8. The exposure system according to any one of claims 1 to 7,
wherein the wafer exposed by the exposure apparatus is developed by a developing apparatus.

9. The exposure system according to any one of claims 1 to 8,

wherein the second surface of the wafer includes a surface of the photosensitive material or a surface of a film covering the photosensitive material, and
wherein the second surface of the exposure apparatus is irradiated with an energy beam.

10. The exposure system according to any one of claims 1 to 9,

wherein the holding apparatus holds a first position of the first surface of the wafer,
wherein the first direction is a thickness direction of the wafer at the first position,
wherein the first measurement part measures a position in the thickness direction at a second position of the second surface of the wafer, and
wherein the second measurement part measures a position in the thickness direction at a third position different from the second position in the first surface or the second surface of the wafer.

11. An exposure system comprising:

a measurement apparatus which is able to acquire information on a shape of a wafer;
an exposure apparatus which exposes the wafer with an energy beam;
a transport apparatus which transports the wafer to the exposure apparatus; and
a control apparatus,
wherein the control apparatus controls the transporting of the wafer using the transport apparatus based on a measurement result of the measurement apparatus.

12. The exposure system according to any one of claims 1 to 11,
wherein the control apparatus controls a speed or acceleration of transporting the wafer by the transport apparatus based on the measurement result.

13. The exposure system according to any one of claims 1 to 12,
wherein the control apparatus controls a transport path of transporting the wafer by the transport apparatus based on the measurement result.

14. The exposure system according to any one of claims 1 to 13,
wherein the control apparatus controls a squeeze force applied to the wafer by the transport apparatus based on the measurement result.

15. The exposure system according to any one of claims 1 to 14,

wherein the transport apparatus includes a suction apparatus which sucks and holds the wafer, and

wherein the control apparatus controls a suction force of the suction apparatus based on the measurement result.

16. The exposure system according to any one of claims 1 to 15,

wherein the control apparatus controls the transport apparatus so that the wafer is not transported toward the exposure apparatus based on the measurement result.

17. The exposure system according to any one of claims 1 to 16, further comprising:

a temperature control apparatus which controls a temperature of the wafer transported to the exposure apparatus.

18. An exposure system comprising:

a measurement apparatus which is able to measure information on a shape of a wafer;
an exposure apparatus which exposes the wafer with an energy beam;
a temperature control apparatus which controls a temperature of the wafer transported to the exposure apparatus; and
a control apparatus,
wherein the control apparatus controls the temperature of the wafer using the temperature control apparatus based on a measurement result of the measurement apparatus.

19. The exposure system according to claim 18,

wherein the control apparatus controls a time during which the temperature control apparatus heats the wafer or a time during which the temperature control apparatus cools the wafer based on the measurement result.

20. The exposure system according to claim 18 or 19,

wherein the temperature control apparatus includes a suction apparatus which sucks and holds the wafer, and
wherein the control apparatus controls a suction force of the suction apparatus based on the measurement result.

21. The exposure system according to any one of claims 18 to 20,

wherein the temperature control apparatus includes a rotating apparatus which rotates the wafer, and
wherein the control apparatus controls a rotational speed or rotational acceleration of the wafer using the rotating apparatus based on the measurement result.

22. An exposure system comprising:

a measurement apparatus which is able to acquire information on a shape of a wafer;
an exposure apparatus which exposes the wafer with an energy beam;
a rotating apparatus which rotates the wafer transported to the exposure apparatus; and
a control apparatus,
wherein the control apparatus controls a rotational speed or rotational acceleration of the wafer using the rotating apparatus based on a measurement result of the measurement apparatus.

23. An exposure system comprising:

a measurement apparatus which is able to acquire information on a shape of a wafer;
an exposure apparatus which exposes the wafer with an energy beam; and
a control apparatus,
wherein in the exposure apparatus, focus adjustment is performed to adjust a positional relationship between a focal position of the energy beam and a surface of the wafer, and
wherein the control apparatus controls the focus adjustment based on a measurement result of the measurement apparatus.

24. The exposure system according to any one of claims 1 to 23,

wherein the exposure system is managed by a host device, and
wherein the control apparatus transmits information on the measurement result to the host device.

25. The exposure system according to any one of claims 1 to 24,

wherein the control apparatuses stores information on the measurement result as log data.

26. A first holding apparatus included in a transport system transporting a wafer, comprising:

a first base in which a first opening is formed in a third surface;
a first wall portion which has an annular shape and is provided in the third surface to surround the first opening and protrudes in a first direction intersecting the third surface; and
a second wall portion which is provided on the outside of the first wall portion with respect to the first opening in a second direction corresponding to a direction parallel to the third surface and protrudes in the first direction, wherein a height of a tip of the second wall portion in the first direction is lower than a height of a tip of the first wall portion in the first direction, and wherein a gas located between the first base and the wafer is able to be sucked through the first opening.

27. The first holding apparatus according to claim 26, wherein a length of the second wall portion in the second direction is longer than a length of the first wall portion in the second direction.

28. The first holding apparatus according to claim 26 or 27,

   wherein the first wall portion has an elongated oval shape, and
   wherein the first opening is formed at a middle portion in a long axis direction of the first wall portion.

29. The first holding apparatus according to any one of claims 26 to 28,

   wherein the first wall portion has an elongated oval shape,
   wherein in the first base, a discharge hole whose one end is the first opening extends along the third surface, and
   wherein a diameter in a long axis direction of the first wall portion in the first opening is larger than a diameter in a short axis direction of the first wall portion in the first opening.

30. The first holding apparatus according to any one of claims 26 to 29, wherein at least a part of the first wall portion contacts the wafer.

31. A transport system for transporting the wafer, comprising:

   the first holding apparatus according to any one of claims 26 to 30; and
   a second holding apparatus,
   wherein the second holding apparatus includes a second base in which a second opening is formed in a fourth surface, a third wall portion which has an annular shape and is provided in the fourth surface to surround the second opening and protrudes in the first direction, and a fourth wall portion which is provided on the outside of the third wall portion with respect to the second opening in the second direction and protrudes in the first direction,

wherein a height of a tip of the fourth wall portion in the first direction is lower than a height of a tip of the third wall portion in the first direction, and wherein a gas located between the second base and the wafer is able to be sucked through the second opening.

32. The transport system according to claim 31, wherein the first holding apparatus and the second holding apparatus have a symmetrical shape with respect to an axial parallel to the third surface or the fourth surface.

33. The transport system according to claim 31, wherein the first holding apparatus and the second holding apparatus are arranged at symmetrical positions with respect to an axis parallel to the third surface or the fourth surface.

34. A third holding apparatus included in a transport system for transporting a wafer, comprising:

   a third opening which is able to suck a gas;
   a fifth wall portion which has an annular shape and is provided in a fifth surface to surround the third opening and protrudes in a first direction intersecting the fifth surface; and
   a first protrusion which is provided on the outside of the fifth wall portion with respect to the third opening in a second direction corresponding to a direction parallel to the fifth surface,
   wherein a height of a tip of the first protrusion in the first direction is lower than a height of a tip of the fifth wall portion in the first direction.

35. The third holding apparatus according to claim 34, wherein a length of the fifth wall portion in the second direction is longer than a length of the first protrusion in the second direction.

36. The third holding apparatus according to claim 34 or 35,

   wherein a plurality of the first protrusions are provided, and
   wherein the plurality of first protrusions are arranged at intervals in the second direction.

37. The third holding apparatus according to claim 36, wherein a length of a protrusion region in which the plurality of first protrusions are arranged in the second direction is longer than a length of the fifth wall portion in the second direction.

38. The third holding apparatus according to claim 36 or 37,

   wherein a plurality of the first protrusions are provided, and

wherein the plurality of first protrusions are arranged at intervals along the fifth wall portion.

39. The third holding apparatus according to any one of claims 34 to 38,

wherein the fifth wall portion has an elongated oval shape, and

wherein the third opening is formed at a middle portion in a long axis direction of the fifth wall portion.

40. The third holding apparatus according to any one of claims 34 to 39,
wherein at least a part of the fifth wall portion contacts the wafer.

41. A transport system for transporting a wafer, comprising:

the third holding apparatus according to any one of claims 34 to 40; and

a fourth holding apparatus,

wherein the fourth holding apparatus includes a fourth opening which is able to suck a gas, a sixth wall portion which has an annular shape and is provided in a sixth surface to surround the fourth opening and protrudes in a first direction intersecting the sixth surface, and a second protrusion which is provided on the outside of the sixth wall portion with respect to the fourth opening in the second direction, and

wherein a height of a tip of the second protrusion in the first direction is lower than a height of a tip of the sixth wall portion in the first direction.

42. The transport system according to claim 41,
wherein the third holding apparatus and the fourth holding apparatus have a symmetrical shape with respect to an axis parallel to the fifth surface or the sixth surface.

43. The transport system according to claim 41,
wherein the third holding apparatus and the fourth holding apparatus are arranged at symmetrical positions with respect to an axis parallel to the fifth surface or the sixth surface.

44. A fifth holding apparatus included in a transport system for transporting a wafer, comprising:

a second base in which a fifth opening is formed in a seventh surface;

a seventh wall portion which has an annular shape and is provided in the seventh surface to surround the fifth opening and protrudes in a first direction intersecting the seventh surface;

and

a third protrusion which is provided on the seventh wall portion,

wherein a height of a tip of the third protrusion in the first direction is higher than a height of a tip of the seventh wall portion in the first direction, and

wherein a gas located between the second base and the wafer is able to be sucked.

45. The fifth holding apparatus according to claim 44, wherein a length of the third protrusion in the first direction is shorter than a length of the seventh wall portion in the first direction.

46. The fifth holding apparatus according to claim 44 or 45,

wherein a plurality of the third protrusions are provided, and

wherein the plurality of third protrusions are arranged at intervals in a second direction corresponding to a direction parallel to the seventh surface.

47. The fifth holding apparatus according to claim 44 or 45,

wherein a plurality of the third protrusions are provided, and

wherein the plurality of third protrusions are arranged at intervals along the seventh wall portion.

48. The fifth holding apparatus according to any one of claims 44 to 47,

wherein the seventh wall portion includes a first arcuate wall and a second arcuate wall which are formed in an arcuate shape centered on a reference point when viewed from the first direction and are arranged at intervals and a pair of connecting walls which connect end portions of the first arcuate wall and the second arcuate wall to each other, and

wherein the third protrusion is provided only in the first arcuate wall and the second arcuate wall.

49. The fifth holding apparatus according to any one of claims 44 to 48,

wherein the seventh wall portion has an elongated oval shape, and

wherein the fifth opening is formed at a middle portion in a long axis direction of the seventh wall portion.

50. The fifth holding apparatus according to any one of claims 44 to 49,

wherein the seventh wall portion has an elongated oval shape,
wherein in the second base, a discharge hole whose one end is the fifth opening extends along the seventh surface, and
wherein a diameter in a long axis direction of the seventh wall portion in the fifth opening is larger than a diameter in a short axis direction of the seventh wall portion in the fifth opening.

51. The fifth holding apparatus according to any one of claims 44 to 50,
wherein at least a part of the third protrusion contacts the wafer.

52. A transport system for transporting a wafer, comprising:

the fifth holding apparatus according to any one of claims 44 to 51; and
sixth and seventh holding apparatuses,
wherein the sixth holding apparatus includes a third base in which a sixth opening is formed in an eighth surface, an eighth wall portion which has an annular shape and is provided in the eighth surface to surround the sixth opening and protrudes in the first direction, and a fourth protrusion which is provided on the eighth wall portion,
wherein a height of a tip of the fourth protrusion in the first direction is higher than a height of a tip of the eighth wall portion in the first direction,
wherein a gas located between the third base and the wafer is able to be sucked,
wherein the seventh holding apparatus includes a fourth base in which a seventh opening is formed in a ninth surface, a ninth wall portion which has an annular shape and is provided in the ninth surface to surround the seventh opening and protrudes in the first direction, and a fifth protrusion which is provided on the ninth wall portion,
wherein a height of a tip of the fifth protrusion in the first direction is higher than a height of a tip of the ninth wall portion in the first direction, and
wherein a gas located between the fourth base and the wafer is able to be sucked.

53. The transport system according to claim 52,
wherein the fifth holding apparatus, the sixth holding apparatus, and the seventh holding apparatus have a symmetrical shape with respect to a third axis in a direction intersecting at least one surface of the seventh surface, the eighth surface, and the ninth surface.

54. The transport system according to claim 52,
wherein the fifth holding apparatus, the sixth holding apparatus, and the seventh holding apparatus are symmetrically arranged with respect to a third axis in a direction intersecting at least one surface of the seventh surface, the eighth surface, and the ninth surface.

55. An exposure system comprising:

the transport system according to any one of claims 31 to 33, claims 41 to 43, and claims 52 to 54; and
an exposure apparatus which exposes a wafer transported using the transport system with an energy beam.

56. An exposure method for exposing a wafer, comprising:
exposing a wafer by irradiating the wafer transported by the transport system according to any one of claims 31 to 33, claims 41 to 43, and claims 52 to 54 to an energy beam.

57. A device manufacturing method comprising:

an exposure step,
wherein the exposure step includes exposing the wafer coated with a resist using the exposure system according to any one of claims 1 to 25 and 55 and developing the exposed wafer.

58. A device manufacturing method comprising:

an exposure step,
wherein the exposure step includes exposing the wafer whose surface is coated with a resist using the exposure system according to any one of claims 1 to 25 and 55 and developing the exposed wafer.

# FIG. 1

200

# FIG. 2

200

201

202

# FIG. 3

200

# FIG. 4

200

D2    D3

D1

# FIG. 5

## FIG. 6

# FIG. 7

# FIG. 8

FIG. 9

EP 4 471 501 A1

# FIG. 10

17

55A

A2

A2

56bA

57A

58A

56A

56A

56aA

Y

X

Z

EP 4 471 501 A1

# FIG. 11

# FIG. 12

17

55A

56bA

57A

58A
(56A)

56A

56aA

Y
X Z

# FIG. 13

200

202

55C

56aA

56A    56bA    57A

Z1
Z
X    Y
Z2

# FIG. 14

WARPAGE
THRESHOLD
VALUE

THICKNESS

# FIG. 15

15A

75

A4

77d

203e
(203e1)

77c

200

77b

203e
(203e2)

O4

77a

70
(71,72)

A4

X

Y    Z

# FIG. 16

# FIG. 17

15B

200
202
R1
85A
86bA
Vac2
86A
88A    88A
86aA    86cA    87A    88A    88A

Z1
Z
X    Z2    Y

EP 4 471 501 A1

FIG. 18

FIG. 19

(a)   CUTTING LINE A6-A6

(b)   CUTTING LINE A7-A7

(c)   CUTTING LINE A8-A8

FIG. 20

EP 4 471 501 A1

# FIG. 21

# FIG. 22

# FIG. 23

# FIG. 24

## INTERNATIONAL SEARCH REPORT

International application No.

**PCT/JP2022/003289**

### A. CLASSIFICATION OF SUBJECT MATTER

*G03F 7/20*(2006.01)i
FI: G03F7/20 521

According to International Patent Classification (IPC) or to both national classification and IPC

### B. FIELDS SEARCHED

Minimum documentation searched (classification system followed by classification symbols)

G03F7/20

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2006-269867 A (CANON KABUSHIKI KAISHA) 05 October 2006 (2006-10-05) claim 1, paragraphs [0014]-[0019], fig. 1-3 | 11-12, 16 |
| Y | | 1-3, 5, 8-10, 15, 17-22, 24-25, 57-58 |
| A | | 4, 6-7, 13-14, 23, 26-56 |
| Y | JP 2021-136258 A (EBARA CORP.) 13 September 2021 (2021-09-13) claim 1, paragraphs [0032]-[0035], fig. 5 | 1-3, 5, 8-10, 24-25, 57-58 |
| Y | JP 2008-177303 A (TOKYO ELECTRON LTD.) 31 July 2008 (2008-07-31) paragraphs [0045]-[0053], fig. 9, 10 | 15, 17-21 |
| Y | JP 4-239719 A (HITACHI, LTD.) 27 August 1992 (1992-08-27) paragraph [0011], fig. 1 | 19 |
| Y | JP 57-154831 A (HITACHI, LTD.) 24 September 1982 (1982-09-24) specification, p. 5, line 15 to p. 6, line 13, fig. 1 | 21-22 |

☑ Further documents are listed in the continuation of Box C.      ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **29 March 2022** | **19 April 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**

| International application No. |
| --- |
| **PCT/JP2022/003289** |

**C.      DOCUMENTS CONSIDERED TO BE RELEVANT**

| Category* | Citation of document, with indication, where appropriate, of the relevant passages | Relevant to claim No. |
| --- | --- | --- |
| X | JP 10-199947 A (TERATECH CO., LTD.) 31 July 1998 (1998-07-31)<br>claim 1, paragraphs [0011]-[0018], fig. 1-11 | 23 |
| A | JP 2001-185607 A (CANON KABUSHIKI KAISHA) 06 July 2001 (2001-07-06)<br>paragraph [0049], fig. 9 | 1-58 |

Form PCT/ISA/210 (second sheet) (January 2015)

<table>
<tr><td colspan="2" align="center">**INTERNATIONAL SEARCH REPORT**<br>Information on patent family members</td><td colspan="2">International application No.<br><br>**PCT/JP2022/003289**</td></tr>
<tr><td align="center">Patent document<br>cited in search report</td><td align="center">Publication date<br>(day/month/year)</td><td align="center">Patent family member(s)</td><td align="center">Publication date<br>(day/month/year)</td></tr>
<tr><td>JP    2006-269867  A</td><td>05 October 2006</td><td>US    2006/0216025  A1<br>claim 1, paragraphs [0024]-[00<br>32], fig. 1-3</td><td></td></tr>
<tr><td>JP    2021-136258  A</td><td>13 September 2021</td><td>(Family: none)</td><td></td></tr>
<tr><td>JP    2008-177303  A</td><td>31 July 2008</td><td>US    2008/0171131  A1<br>paragraphs [0097]-[0108], fig.<br>11, 12<br>KR  10-2008-0067972    A</td><td></td></tr>
<tr><td>JP    4-239719  A</td><td>27 August 1992</td><td>(Family: none)</td><td></td></tr>
<tr><td>JP    57-154831  A</td><td>24 September 1982</td><td>(Family: none)</td><td></td></tr>
<tr><td>JP    10-199947  A</td><td>31 July 1998</td><td>(Family: none)</td><td></td></tr>
<tr><td>JP    2001-185607  A</td><td>06 July 2001</td><td>(Family: none)</td><td></td></tr>
</table>

Form PCT/ISA/210 (patent family annex) (January 2015)

**REFERENCES CITED IN THE DESCRIPTION**

**Patent documents cited in the description**

- US 6852644 B